# EUROPEAN PATENT APPLICATION

(11) **EP 4 546 995 A1**
(43) Date of publication of application: **30.04.2025**
(21) Application number: 24206461.6
(22) Date of filing: 14.10.2024
(51) Int. Cl.: H10K 59/80

(54) **DISPLAY DEVICE AND METHOD FOR MANUFACTURING THE DISPLAY DEVICE**

(30) Priority: 19.10.2023 KR 20230140197
(71) Applicant: Samsung Display Co., Ltd., Gyeonggi-do 17113 (KR)
(72) Inventor: Lee, Kyong Chol, Yongin-si, Gyeonggi-do (KR); Yeo, Yun Jong, Yongin-si, Gyeonggi-do (KR); Jung, Da Woon, Yongin-si, Gyeonggi-do (KR); Jeong, Jae Woo, Yongin-si, Gyeonggi-do (KR); Cho, Hyun Min, Yongin-si, Gyeonggi-do (KR)
(74) Representative: Gulde & Partner

(57) **Abstract**

A display device and method for manufacturing the display device includes, a substrate, a light emitting element layer disposed on the substrate and including at least one light emitting element, and a light control layer disposed on the light emitting element layer, wherein the light control layer includes, a plurality of light blocking films disposed to be spaced apart from each other, at least one bridge connecting at least two of the plurality of light blocking films, and a light transmitting film disposed between the plurality of light blocking films and the bridge.

## Description

### BACKGROUND

### 1. Technical Field

The present invention relates to a display device, and more particularly to a display device and a method for manufacturing the display device.

### 2. Description of the Related Art

As an information society develops, the demand for a display device for displaying an image is increasing in various forms. The display device may be a flat panel display, such as a liquid crystal display, a field emission display, or a light emitting display panel. The light emitting display device may include an organic light emitting diode display device including an organic light emitting diode element as a light emitting element or a light emitting diode display device including an inorganic light emitting diode element such as a light emitting diode (LED) as a light emitting element.

In the case of a vehicle display device, when an image displayed on the vehicle display device disposed in front of a driver or passenger is reflected onto a windshield at night, it may interfere with the driver's driving or it may have a negative impact on privacy as the reflection of the image may inadvertently be displayed to the wrong person.

### SUMMARY

Aspects of the invention provide a display device with improved viewing angle control characteristics and luminance characteristics and a method for manufacturing the display device. The improved viewing angle control characteristics can be advantageously improved by at least one light blocking films over a light emitting layer.

Aspects of the invention also provide a display device with improved process efficiency and a method for manufacturing the display device.

Aspects of the invention also provide a display device that prevents a collapse of a light blocking film and a method for manufacturing the display device. The collapse of a light blocking film can be advantageously prevented by at least one bridge.

However, the invention is not restricted to those embodiments set forth herein. The above and other aspects of the invention will become more apparent to one of ordinary skill in the art to which the present invention pertains by referencing the detailed description of the invention given below.

According to an aspect of the present invention, there is provided a display device including a substrate, a light emitting element layer disposed on the substrate and including at least one light emitting element, and a light control layer disposed on the light emitting element layer, wherein the light control layer includes, a plurality of light blocking films disposed to be spaced apart from each other, and a light transmitting film disposed between the plurality of light blocking films and the bridge, wherein the light control layer further includes at least one bridge connecting at least two of the plurality of light blocking films and/or at least one of the plurality of light blocking films includes removal marks on a side surface thereof.

In an embodiment, the light transmitting film includes a first portion positioned at the same height as the plurality of light blocking films, and a second portion disposed on the plurality of light blocking films.

In an embodiment, the second portion is disposed across the plurality of light blocking films, the bridge, and the first portion.

In an embodiment, the bridge extends in a different direction from the plurality of light blocking films.

In an embodiment, a width of the bridge is different from a width of the plurality of light blocking films.

In an embodiment, the width of the bridge is greater than the width of the plurality of light blocking films.

In an embodiment, the bridge includes the same material as the plurality of light blocking films.

In an embodiment, the display device may further include a light emitting area from which light emitted by the light emitting element is emitted, wherein the bridge does not overlap the light emitting area.

In an embodiment, the bridge connects at least two light blocking films among the plurality of light blocking films.

In an embodiment, the bridge includes a first bridge disposed between a (2n-1)-th light blocking film and a (2n)-th light blocking film among the plurality of light blocking films, and a second bridge disposed between the (2n)-th light blocking film and a (2n+1)-th light blocking film among the plurality of light blocking films, where n is a natural number, and where the first bridge and the second bridge do not overlap each other.

In an embodiment, the light transmitting film surrounds the plurality of light blocking films and the bridge.

In an embodiment, the light control layer includes a first stage and a second stage disposed on the first stage, where the first stage and the second stage each include the plurality of light blocking films and the light transmitting film.

In an embodiment, the removal mark is a concave portion or a convex portion.

In an embodiment, the plurality of light blocking films include a first side surface and a second side surface positioned on an opposite side of the first side surface, and both of the first side surface and the second side surface include the concave portion, or both of the first side surface and the second side surface include the convex portion.

In an embodiment, the plurality of light blocking films include a first side surface and a second side surface positioned on an opposite side of the first side surface, where the first side surface includes the concave portion and the second side surface includes the convex portion, or the first side surface includes the convex portion and the second side surface includes the concave portion.

In an embodiment, the plurality of light blocking films include a first side surface and a second side surface positioned on an opposite side of the first side surface, the first side surface and the second side surface each include both the concave portion and the convex portion, the concave portion of the first side surface and the convex portion of the second side surface overlap, and the convex portion of the first side surface and the concave portion of the second side surface overlap.

In an embodiment, the display device may further include a light emitting area from which light emitted by the light emitting element is emitted, wherein at least one of the removal marks overlaps the light emitting area.

According to an embodiment, the at least one light emitting element is included in at least one pixel included in the light emitting element layer, wherein the at least one pixel includes a first light emitting mode area and a second light emitting mode area, the plurality of light blocking films include a first light blocking film disposed in the first light emitting mode area and a second light blocking film disposed in the second light emitting mode area, where the extension directions of the first light blocking film and the second light blocking film are different.

In an embodiment, the first light blocking film and the second light blocking film are connected to each other at a boundary between the first light emitting mode area and the second light emitting mode area.

In an embodiment, a distance between the first light blocking films is different from a distance between the second light blocking films.

According to an embodiment, there is provided a method for manufacturing a display device, the method including forming a light blocking material layer, forming a plurality of light blocking films and a bridge by patterning the light blocking material layer, and forming a light transmitting material layer surrounding the plurality of light blocking films and the bridge, wherein the extension directions of the bridge and the plurality of light blocking films are different.

In an embodiment, the method may further include removing a portion of the light transmitting material layer and the bridge, and forming a light transmitting film by filling the removed light transmitting material layer.

In an embodiment, in the removing of the bridge, a removal mark of the bridge is formed on a side surface of the plurality of light blocking films.

According to an embodiment, the display device and the method for manufacturing the display device, the viewing angle control characteristics and luminance characteristics may be improved.

According to an embodiment, the display device and the method for manufacturing the display device, the process efficiency may be improved.

According to an embodiment, the display device and the method for manufacturing the display device, a collapse of a light blocking film may be prevented.

However, the embodiments are not restricted to the ones set forth herein.

### BRIEF DESCRIPTION OF THE DRAWINGS

The above and other aspects and features of the invention will become more apparent by describing in detail embodiments thereof with reference to the attached drawings, in which:
FIG. 1 is an exploded perspective view illustrating a display device, according to an embodiment;
FIG. 2 is a plan view illustrating a display device, according to an embodiment;
FIG. 3 is a schematic cross-sectional view of the display device taken along line X1-X1' of FIG. 2, according to an embodiment;
FIG. 4 is a cross-sectional view illustrating an example of a display panel, according to an embodiment;
FIG. 5 is a perspective view illustrating an example of an electronic device, according to an embodiment;
FIG. 6 is a plan view illustrating an example of the display device, according to an embodiment;
FIG. 7 is a plan view illustrating a pixel and a light control layer of the display device, according to an embodiment;
FIG. 8 is a cross-sectional view taken along line X2-X2' of FIG. 7, according to an embodiment;
FIG. 9 is a cross-sectional view taken along line X3-X3' of FIG. 7, according to an embodiment;
FIG. 10 is a plan view illustrating a pixel and a light control layer of a display device, according to another embodiment;
FIG. 11 is a plan view illustrating a pixel and a light control layer of a display device, according to still another embodiment;
FIG. 12 is a plan view illustrating pixels and light control layers of a display device, according to still another embodiment;
FIG. 13 is a plan view illustrating pixels and light control layers of a display device, according to still another embodiment;
FIG. 14 is a plan view illustrating pixels and light control layers of a display device, according to still another embodiment;
FIG. 15 is a plan view illustrating pixels and light control layers of a display device, according to still another embodiment;
FIG. 16 is a plan view illustrating a pixel and a light control layer of a display device, according to still another embodiment;
FIG. 17 is a cross-sectional view illustrating a display device, according to still another embodiment;
FIG. 18 is a flowchart illustrating a method for manufacturing a display device, according to an embodiment;
FIG. 19 is a perspective view illustrating step S110 of FIG. 18, according to an embodiment;
FIG. 20 is a perspective view illustrating step S120 of FIG. 18, according to an embodiment;
FIG. 21 is a perspective view illustrating step S120 of FIG. 18, according to an embodiment;
FIG. 22 is a perspective view illustrating step S130 of FIG. 18, according to an embodiment;
FIG. 23 is a perspective view illustrating step S140 of FIG. 18, according to an embodiment;
FIG. 24 is a perspective view illustrating step S140 of FIG. 18, according to an embodiment;
FIG. 25 is a perspective view illustrating step S150 of FIG. 18, according to an embodiment;
FIG. 26 is a flowchart illustrating a method for manufacturing a display device, according to another embodiment;
FIG. 27 is a perspective view illustrating step S210 of FIG. 26, according to an embodiment;
FIG. 28 is a perspective view illustrating step S220 of FIG. 26, according to an embodiment;
FIG. 29 is a perspective view illustrating step S220 of FIG. 26, according to an embodiment;
FIG. 30 is a perspective view illustrating step S230 of FIG. 26, according to an embodiment;
FIG. 31 is a perspective view illustrating step S240 of FIG. 26, according to an embodiment;
FIG. 32 is a perspective view illustrating step S250 of FIG. 26, according to an embodiment;
FIG. 33 is a perspective view illustrating step S250 of FIG. 26, according to an embodiment;
FIG. 34 is a perspective view illustrating step S260 of FIG. 26, according to an embodiment;
FIG. 35 is a perspective view illustrating step S270 of FIG. 26, according to an embodiment; and
FIG. 37 is a perspective view illustrating step S280 of FIG. 26, according to an embodiment.

### DETAILED DESCRIPTION OF THE EMBODIMENTS

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being disposed "on," "connected to," or "coupled to" another element, layer or substrate, it can be directly on the other layer or substrate, or intervening layers may also be present. To this end, the term "connected" may refer to physical, electrical, and/or fluid connection, with or without intervening elements. The same reference numbers indicate the same components throughout the specification.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Unless otherwise specified, the illustrated embodiments are to be understood as providing features of varying detail of some ways in which the disclosure may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

Features of various embodiments of the invention may be combined partially or totally. As will be clearly appreciated by those skilled in the art, technically various interactions and operations are possible. Various embodiments can be practiced individually or in combination.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not intended to be limiting.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the invention. Further, the blocks, units, parts, and/or modules of some embodiments may be physically combined into more complex blocks, units, parts, and/or modules without departing from the scope of the invention.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments of the invention will be described in detail with reference to the accompanying drawings.

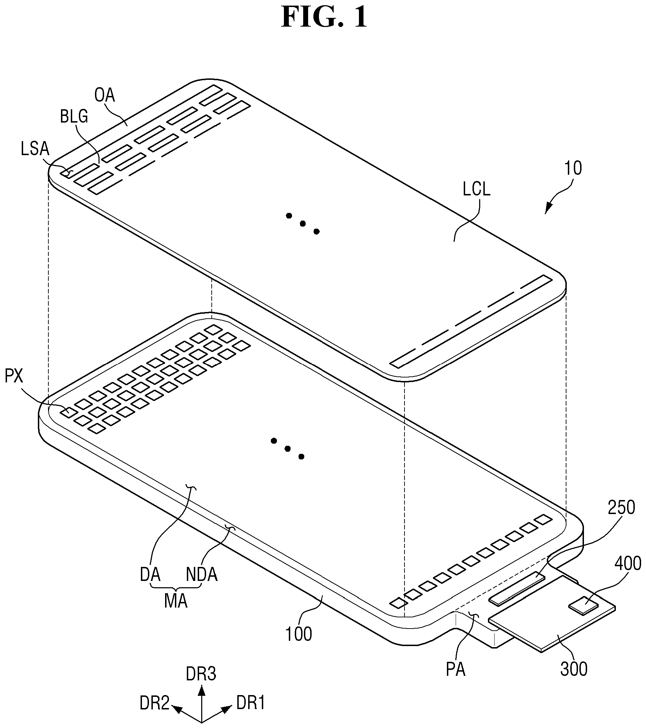

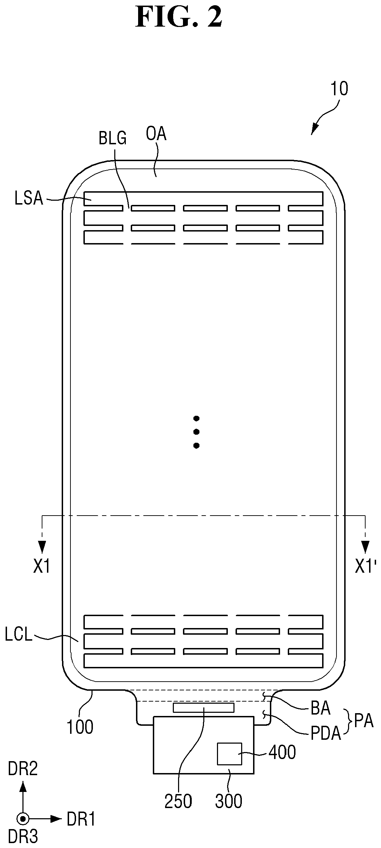

FIG. 1 is an exploded perspective view illustrating a display device, according to an embodiment. FIG. 2 is a plan view illustrating a display device, according to an embodiment.

In an embodiment and referring to FIGS. 1 and 2, a display device 10 is a device that displays a moving image or a still image, and may be used as a display screen of each of various products such as a television, a laptop computer, a monitor, a billboard, and an Internet of Things (IOT) device as well as portable electronic devices such as a mobile phone, a smartphone, a tablet personal computer (PC), a smartwatch, a watch phone, a mobile communication terminal, an electronic organizer, an electronic book, a portable multimedia player (PMP), a navigation device, and an ultra mobile PC (UMPC). The display device 10 may be any one of an organic light emitting display device, a liquid crystal display device, a plasma display device, a field emission display device, an electrophoretic display device, an electrowetting display device, a quantum dot light emitting display device, and a micro LED display device. Hereinafter, it is mainly described that the display device 10 is the organic light emitting display device, but the invention is not limited thereto.

In an embodiment, the display device 10 may include a display panel 100, a display driving circuit 250, a circuit board 300, and a touch driving circuit 400.

In an embodiment, the display panel 100 may include a plurality of pixels PX arranged in a first direction DR1 and a second direction DR2. Each of the pixels PX may have a planar shape such as a rectangle, a square, or a rhombus. For example, as illustrated in the drawing, each of the pixels PX may have a planar shape such as a square. However, each of the pixels PX is not limited thereto, and may have various shapes such as a polygon, a circle, and an ellipse in a plan view.

In the illustrated drawings, the first direction DR1 and the second direction DR2 are each horizontal direction and intersect each other. For example, the first direction DR1 and the second direction DR2 may be orthogonal to each other. In addition, a third direction DR3 may be a vertical direction intersecting the first direction DR1 and the second direction DR2, for example, orthogonal to the first direction DR1 and the second direction DR2.

In an embodiment, the display panel 100 may include a main area MA and a protruding area PA protruding from one side of the main area MA.

In an embodiment, the main area MA may be formed in a rectangular plane having a short side in the first direction DR1 and a long side in the second direction DR2 intersecting the first direction DR1. A corner where the short side in the first direction DR1 and the long side in the second direction DR2 meet may be rounded to have a predetermined curvature or may be formed at a right angle. The planar shape of the display device 10 is not limited to a quadrangular shape, and may be formed in other polygonal, circular, or oval shapes. The main area MA may be formed to be flat, but is not limited thereto, and may include curved portions formed at left and right ends. In this case, the curved portion may have a constant curvature or a changing curvature.

In an embodiment, the main area MA may include a display area DA in which pixels are formed to display an image, and a non-display area NDA which is a peripheral area of the display area DA.

In an embodiment, in the display area DA, not only pixels but also scan lines, data lines, and power lines connected to the pixels may be disposed. When the main area MA includes the curved portion, the display area DA may be disposed on the curved portion. In this case, the image of the display panel 100 may be viewed even on the curved portion.

In an embodiment, the non-display area NDA may be defined as an area from the outside of the display area DA to an edge of the display panel 100. A scan driver for applying scan signals to the scan lines and link lines connecting the data lines and the display driving circuit 250 may be disposed in the non-display area NDA.

In an embodiment, the protruding area PA may protrude from one side of the main area MA. For example, the protruding area PA may protrude from a lower side of the main area MA as illustrated in FIG. 2. A length of the protruding area PA in the first direction DR1 may be smaller than a length of the main area MA in the first direction DR1.

In an embodiment, the protruding area PA may include a bending area BA and a pad area PDA. In this case, the pad area PDA may be disposed on one side of the bending area BA, and the main area MA may be disposed on the other side of the bending area BA. For example, the pad area PDA may be disposed on a lower side of the bending area BA, and the main area MA may be disposed on an upper side of the bending area BA.

In an embodiment, the display panel 100 may be flexibly formed to be curved, bent, folded, or rolled. Therefore, the display panel 100 may be bent in a thickness direction, that is, in a third direction DR3, in the bending area BA. In this case, before the display panel 100 is bent, one surface of the pad area PDA of the display panel 100 faces upward, but after the display panel 100 is bent, one surface of the pad area PDA of the display panel 100 faces downward. As a result, since the pad area PDA is disposed on a lower side of the main area MA, the pad area PDA may overlap the main area MA.

In an embodiment, pads electrically connected to the display driving circuit 250 and the circuit board 300 may be disposed in the pad area PDA of the display panel 100.

In an embodiment, the display driving circuit 250 outputs signals and voltages for driving the display panel 100. For example, the display driving circuit 250 may supply data voltages to the data lines. In addition, the display driving circuit 250 may supply power voltage to the power line and scan control signals to a scan driver. The display driving circuit 250 may be formed as an integrated circuit (IC) and be attached onto the display panel 100 in the pad area PDA using a chip on glass (COG) method, a chip on plastic (COP) method, or an ultrasonic bonding method, but is not limited thereto. For example, the display driving circuit 250 may be mounted on the circuit board 300.

In an embodiment, the pads may include display pads electrically connected to the display driving circuit 250 and touch pads electrically connected to the touch lines.

In an embodiment, the circuit board 300 may be attached onto the pads using an anisotropic conductive film. Accordingly, lead lines of the circuit board 300 may be electrically connected to the pads. The circuit board 300 may be a flexible printed circuit board, a printed circuit board, or a flexible film such as a chip on film.

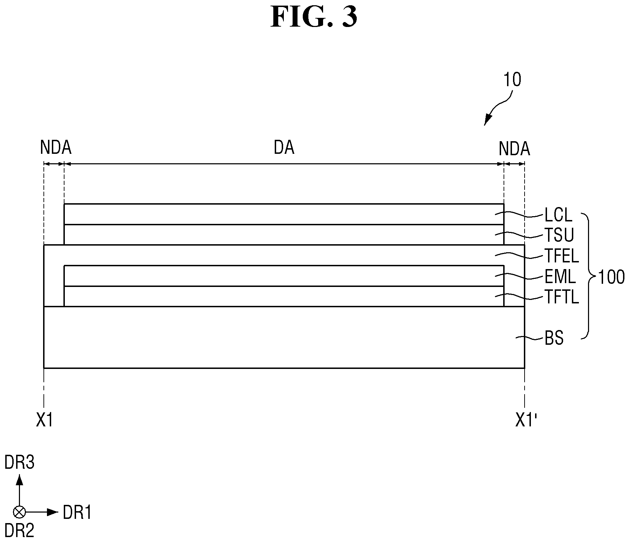

In an embodiment, the touch driving circuit 400 may be connected to touch electrodes of a touch sensor layer TSU (see FIG. 3) of the display panel 100. The touch driving circuit 400 applies driving signals to the touch electrodes of the touch sensor layer TSU (see FIG. 3) and measures capacitance values of the touch electrodes. The driving signal may be a signal having a plurality of driving pulses. The touch driving circuit 400 may not only determine whether a touch is input but also calculate touch coordinates where a touch is input, based on the capacitance values.

In an embodiment, the touch driving circuit 400 may be disposed on the circuit board 300. The touch driving circuit 400 may be formed as an integrated circuit (IC) and mounted on the circuit board 300.

In an embodiment, in the display device 10, the display panel 100 may further include a light control layer LCL.

In an embodiment, the light control layer LCL may be directly disposed in the main area MA of the display panel 100. For example, the light control layer LCL may be embedded in the display panel 100 and directly disposed on the main area MA of the display panel 100. As the light control layer LCL is embedded in the display panel 100, the thickness and manufacturing cost of the display device 10 may be reduced as compared to when a separate light control film is attached.

In some embodiments, the light control layer LCL may be disposed on the display area DA of the main area MA. The light control layer LCL may control a viewing angle of light emitted from the display panel 100.

However, in an embodiment, the invention is not limited thereto, and a size of the light control layer LCL in a plan view may be greater than a size of the display area DA. In this case, the light control layer LCL may overlap both the display area DA and the non-display area NDA.

In some embodiments, as illustrated in FIGS. 1 and 2, the light control layer LCL may include a transmissive area OA and a non-transmissive area LSA.

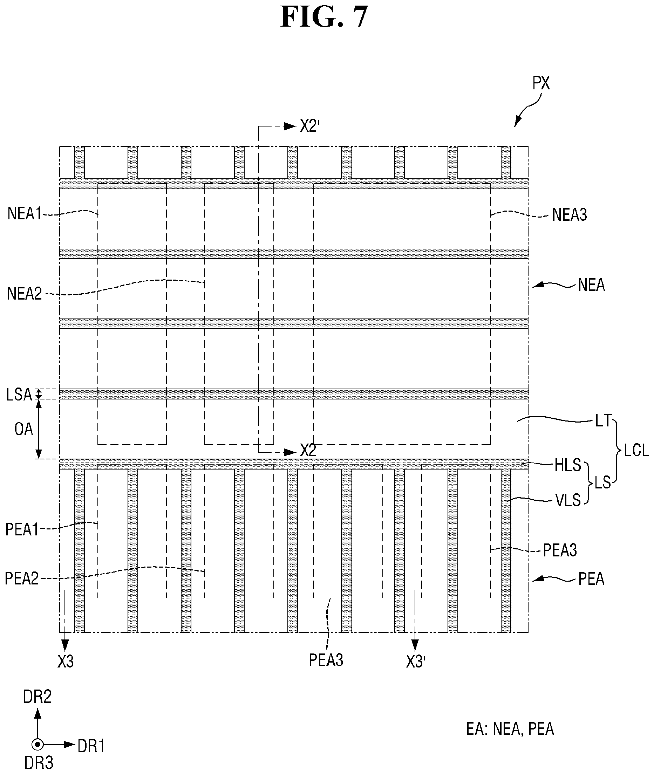

In an embodiment, the transmissive area OA may be an area in which the plurality of light blocking films LS (see FIG. 7) is not disposed. The transmissive area OA, which is an area that transmits light, may extend along the third direction DR3.

In an embodiment, the transmissive area OA may have a quadrangular shape in a plan view as illustrated in FIGS. 1 and 2, but is not limited thereto. Each of the transmissive areas OA may have a circular, oval, or polygonal shape in a plan view. In some embodiments, the shape of the transmissive area OA may substantially correspond to the shape of the display panel 100.

In an embodiment, the non-transmissive area LSA may be a remaining area of the light control layer LCL excluding the transmissive area OA. The non-transmissive areas LSA may be areas in which the plurality of light blocking films LS (see FIG. 7) is disposed.

In some embodiments, the non-transmissive areas LSA may extend in the first direction DR1 or the second direction DR2. In an embodiment, as illustrated in FIG. 1, the non-transmissive areas LSA may extend in the first direction DR1 and be disposed along the second direction DR2. In another embodiment, the non-transmissive areas LSA may extend in the second direction DR2 and be disposed along the first direction DR1. In still another embodiment, some of the non-transmissive areas LSA may extend in the first direction DR1 and be disposed along the second direction DR2, and the remaining portion of the non-transmissive areas LSA may extend in the second direction DR2 and be disposed along the first direction DR1.

In an embodiment, as illustrated in FIG. 3, when the non-transmissive areas LSA are disposed along the second direction DR2, the viewing angle may be controlled in the second direction DR2. In another embodiment, when the non-transmissive areas LSA are disposed along the first direction DR1, the viewing angle may be controlled in the first direction DR1. In the display device 10 according to an embodiment, the arrangement and shape of the transmissive area OA and the non-transmissive area LSA may be variously changed depending on the required control direction of the viewing angle.

In an embodiment, it is illustrated in the drawings that the transmissive area OA is disposed to surround the non-transmissive area LSA, but the invention is not limited thereto. In some embodiments, the transmissive area OA extends in the same direction as the non-transmissive area LSA, so that the transmissive area OA and the non-transmissive area LSA may be alternately disposed. For example, in an embodiment and as illustrated in FIG. 1, when the non-transmissive area LSA extends in the first direction DR1, the transmissive area OA may extend in the first direction DR1 and may be disposed alternately with the non-transmissive area LSA in the second direction DR2.

In some embodiments, the display device 10 may further include a bridge BLG.

In an embodiment, the bridge BLG may be disposed between the non-transmissive areas LSA. For example, as illustrated in the drawings, when the non-transmissive areas LSA are disposed in the second direction DR2, the bridge BLG may be disposed between the non-transmissive areas LSA in the second direction DR2.

In an embodiment, the bridge BLG may extend in a different direction from the non-transmissive area LSA. For example, as illustrated in the drawings, when the non-transmissive areas LSA extend in the first direction DR1, the bridge BLG may extend in the second direction DR2.

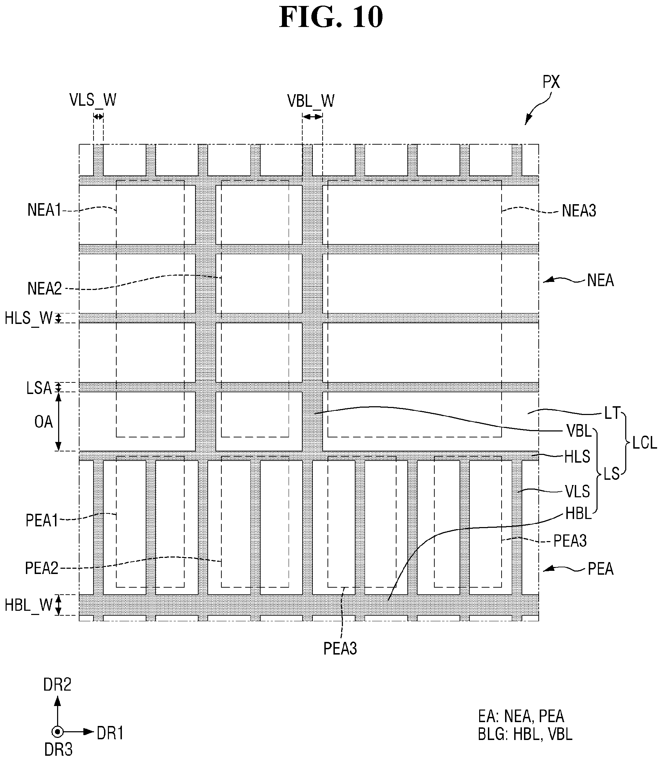

In an embodiment, the bridge BLG will be described with reference to FIG. 10 and the like.

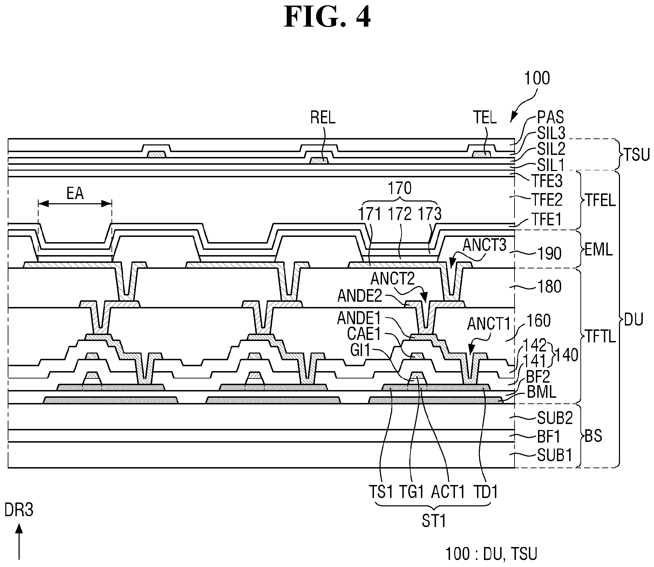

In an embodiment, the light control layer LCL may include a plurality of light blocking films LS (see FIG. 7) that blocks light emitted from a light emitting layer 172 (see FIG. 4) of the display panel 100 and a light transmitting film LT (see FIG. 7) that transmits the light. The detailed structure of the light control layer LCL will be described later with reference to FIG. 7 and the like.

FIG. 3 is a schematic cross-sectional view of the display device taken along line X1-X1' of FIG. 2, in an embodiment.

In an embodiment and referring to FIG. 3, the display device 10 may include a display panel 100 in which the light control layer LCL is embedded. The display panel 100 may include a base member BS, a thin film transistor layer TFTL, a light emitting element layer EML, a thin film encapsulation layer TFEL, a touch sensor layer TSU, and a light control layer LCL.

In an embodiment, the base member BS may include a substrate. The substrate may be made of an insulating material such as glass, quartz, or a polymer resin. Examples of the polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. In another embodiment, the substrate may also include a metal material.

In an embodiment, the substrate may be a rigid substrate or may be a flexible substrate that may be bent, folded, and rolled. When the substrate is the flexible substrate, the substrate may be formed of polyimide PI, but is not limited thereto.

In an embodiment, the thin film transistor layer TFTL may be disposed on the base member BS. In the thin film transistor layer TFTL, scan lines, data lines, power lines, scan control lines, and routing lines connecting pads and the data lines as well as thin film transistors of each of the pixels may be formed. Each of the thin film transistors may include a gate electrode, a semiconductor layer, a source electrode, and a drain electrode.

In an embodiment, the thin film transistor layer TFTL may be disposed in the display area DA and the non-display area NDA. Specifically, the thin film transistors of each of the pixels, the scan lines, the data lines, and the power lines of the thin film transistor layer TFTL may be disposed in the display area DA. The scan control lines and link lines of the thin film transistor layer TFTL may be disposed in the non-display area NDA.

In an embodiment, the light emitting element layer EML may be disposed on the thin film transistor layer TFTL. The light emitting element layer EML may include pixels including a first electrode, a light emitting layer, and a second electrode, and a pixel defining film defining the pixels. The light emitting layer may be an organic light emitting layer including an organic material. In this case, the light emitting layer may include a hole transporting layer, an organic light emitting layer, and an electron transporting layer. When a predetermined voltage is applied to the first electrode and a cathode voltage is applied to the second electrode through the thin film transistor of the thin film transistor layer TFTL, holes and electrons move to the organic light emitting layer through the hole transporting layer and the electron transporting layer, respectively, and combine with each other in the organic light emitting layer to emit light. The pixels of the light emitting element layer EML may be disposed in the display area DA.

In an embodiment, the thin film encapsulation layer TFEL may be disposed on the light emitting element layer EML. The thin film encapsulation layer TFEL may serve to prevent oxygen or moisture from permeating into the light emitting element layer EML. To this end, the thin film encapsulation layer TFEL may include at least one inorganic film. The inorganic film may be a silicon nitride layer, a silicon oxynitride layer, a silicon oxide layer, a titanium oxide layer, or an aluminum oxide layer, but is not limited thereto. In addition, the thin film encapsulation layer TFEL may serve to protect the light emitting element layer EML from foreign substances such as dust. To this end, the thin film encapsulation layer TFEL may include at least one organic film. The organic film may be made of an acrylic resin, an epoxy resin, a phenolic resin, a polyamide resin, or a polyimide resin, but is not limited thereto.

In an embodiment, the thin film encapsulation layer TFEL may be disposed in both the display area DA and the non-display area NDA. Specifically, the thin film encapsulation layer TFEL may be disposed to cover the light emitting element layer EML of the display area DA and the non-display area NDA, and cover the thin film transistor layer TFTL of the non-display area NDA.

In an embodiment, the touch sensor layer TSU may be disposed on the thin film encapsulation layer TFEL. As the touch sensor layer TSU is directly disposed on the thin film encapsulation layer TFEL, the thickness of the display device 10 may be reduced as compared to when a separate touch panel including the touch sensor layer TSU is attached onto the thin film encapsulation layer TFEL.

In an embodiment, the touch sensor layer TSU may include touch electrodes for sensing a user's touch in a capacitance method, and touch lines connecting the pads and the touch electrodes. For example, the touch sensor layer TSU may sense a user's touch in a self-capacitance method or a mutual capacitance method.

In an embodiment, the touch electrodes of the touch sensor layer TSU may be disposed in a touch sensor area overlapping the display area DA. The touch lines of the touch sensor layer TSU may be disposed in a touch peripheral area overlapping the non-display area NDA.

In an embodiment, a light control layer LCL may be disposed on the touch sensor layer TSU. The light control layer LCL may be disposed to overlap display area DA. The light control layer LCL may serve to absorb or block light that travels beyond a certain angle with respect to the third direction DR3 among the light emitted from the light emitting element layer EML. That is, the light control layer LCL may control the viewing angle.

In an embodiment, although not illustrated in the drawing, the display device 10 may further include a cover window. The cover window may be additionally disposed on the light control layer LCL. In this case, the light control layer LCL and the cover window may be attached by a transparent adhesive member such as an optically clear adhesive (OCA) film.

FIG. 4 is a cross-sectional view illustrating an example of a display panel, according to an embodiment.

In an embodiment and referring to FIG. 4, the display panel 100 may include a display layer DU and a touch sensor layer TSU. The display layer DU may include a base member BS, a thin film transistor layer TFTL, a light emitting element layer EML, and a thin film encapsulation layer TFEL.

In an embodiment, the base member BS may include a first substrate SUB1, a first buffer film BF1 disposed on the first substrate SUB1, and a second substrate SUB2 disposed on the first buffer film BF1.

In an embodiment, the first substrate SUB1 and the second substrate SUB2 may be made of an insulating material such as glass, quartz, or polymer resin. Examples of the polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. In another embodiment, the substrate may also include a metal material.

In an embodiment, the first substrate SUB1 and the second substrate SUB2 may be rigid substrates or flexible substrates that may be bent, folded, and rolled. When the substrate is the flexible substrate, the substrate may be formed of polyimide PI, but is not limited thereto.

In an embodiment, the first buffer film BF1 is a film for protecting a first thin film transistor ST1 and a light emitting layer 172 from moisture permeating through the first and second substrates SUB1 and SUB2, which are vulnerable to moisture permeation. The first buffer film BF1 may be formed of a plurality of inorganic layers alternately stacked. For example, the first buffer film BF1 may be formed of multiple films in which one or more inorganic films of a silicon nitride layer, a silicon oxynitride layer, a silicon oxide layer, a titanium oxide layer, and an aluminum oxide layer are alternately stacked.

In an embodiment, the thin film transistor layer TFTL may include a lower metal layer BML, a second buffer film BF2, a first thin film transistor ST1, a first gate insulating film GI1, a first interlayer insulating film 141, a first capacitor electrode CAE1, a second interlayer insulating film 142, a first anode connection electrode ANDE1, a first organic film 160, a second anode connection electrode ANDE2, and a second organic film 180.

In an embodiment, the lower metal layer BML may be disposed on the second substrate SUB2. The lower metal layer BML may be disposed to overlap a first active layer ACT1 of the first thin film transistor ST1 in the third direction DR3 to prevent leakage current from occurring when light is incident on the first active layer ACT1 of the first thin film transistor ST1. The lower metal layer BML may be formed as a single layer or multiple layers made of any one of molybdenum (Mo), aluminum (Al), chromium (Cr), gold (Au), titanium (Ti), nickel (Ni), neodymium (Nd), and copper (Cu), or an alloy thereof. The lower metal layer BML may be omitted.

In an embodiment, the second buffer film BF2 may be disposed on the lower metal layer BML. The second buffer film BF2 is a film for protecting the first thin film transistor ST1 and the light emitting layer 172 from moisture permeating through the first and second substrates SUB1 and SUB2, which are vulnerable to moisture permeation. The second buffer film BF2 may be formed of a plurality of inorganic layers alternately stacked. For example, the second buffer film BF2 may be formed of multiple films in which one or more inorganic films of a silicon nitride layer, a silicon oxynitride layer, a silicon oxide layer, a titanium oxide layer, and an aluminum oxide layer are alternately stacked.

In an embodiment, the first active layer ACT1 of the first thin film transistor ST1 may be disposed on the second buffer film BF2. The first active layer ACT1 of the first thin film transistor ST1 includes polycrystalline silicon, single crystal silicon, low-temperature polycrystalline silicon, amorphous silicon, or an oxide semiconductor. The first active layer ACT1 of the first thin film transistor ST1 exposed and not covered by the first gate insulating film GI1 may be doped with impurities or ions to have conductivity. Therefore, a first source electrode TS1 and a first drain electrode TD1 of the first active layer ACT1 of the first thin film transistor ST1 may be formed.

In an embodiment, the first gate insulating film GI1 may be disposed on the first active layer ACT1 of the first thin film transistor ST1. It is illustrated in FIG. 4 that the first gate insulating film GI1 is disposed between a first gate electrode TG1 and the first active layer ACT1 of the first thin film transistor ST1, but the invention is not limited thereto. The first gate insulating film GI1 may also be disposed between the first interlayer insulating film 141 and the first active layer ACT1 and between the first interlayer insulating film 141 and the second buffer film BF2. The first gate insulating film GI1 may be formed as an inorganic film, for example, a silicon nitride layer, a silicon oxynitride layer, a silicon oxide layer, a titanium oxide layer, or an aluminum oxide layer.

In an embodiment, the first gate electrode TG1 of the first thin film transistor ST1 may be disposed on the first gate insulating film GI1. The first gate electrode TG1 of the first thin film transistor ST1 may overlap the first active layer ACT1 in the third direction DR3. The first gate electrode TG1 of the first thin film transistor ST1 may be formed as a single layer or a multi-layer made of any one of molybdenum (Mo), aluminum (Al), chromium (Cr), gold (Au), titanium (Ti), nickel (Ni), neodymium (Nd), and copper (Cu), or an alloy thereof.

In an embodiment, the first interlayer insulating film 141 may be disposed on the first gate electrode TG1 of the first thin film transistor ST1. The first interlayer insulating film 141 may be formed as an inorganic film, for example, a silicon nitride layer, a silicon oxynitride layer, a silicon oxide layer, a titanium oxide layer, or an aluminum oxide layer. The first interlayer insulating film 141 may include a plurality of inorganic films.

In an embodiment, the first capacitor electrode CAE1 may be disposed on the first interlayer insulating film 141. The first capacitor electrode CAE1 may overlap the first gate electrode TG1 of the first thin film transistor ST1 in a third direction (Z-axis direction). Since the first interlayer insulating film 141 has a predetermined dielectric constant, a capacitor may be formed by the first capacitor electrode CAE1, the first gate electrode TG1, and the first interlayer insulating film 141 disposed between the first capacitor electrode CAE1 and the first gate electrode TG1. The first capacitor electrode CAE1 may be formed as a single layer or a multi-layer made of any one of molybdenum (Mo), aluminum (Al), chromium (Cr), gold (Au), titanium (Ti), nickel (Ni), neodymium (Nd), and copper (Cu), or an alloy thereof.

In an embodiment, the second interlayer insulating film 142 may be disposed on the first capacitor electrode CAE1. The second interlayer insulating film 142 may be formed as an inorganic film, for example, a silicon nitride layer, a silicon oxynitride layer, a silicon oxide layer, a titanium oxide layer, or an aluminum oxide layer. The second interlayer insulating film 142 may include a plurality of inorganic films.

In an embodiment, the first anode connection electrode ANDE1 may be disposed on the second interlayer insulating film 142. The first anode connection electrode ANDE1 may be connected to the first drain electrode TD1 of the first thin film transistor ST1 through a first anode contact hole ANCT1 penetrating through the first interlayer insulating film 141 and the second interlayer insulating film 142 to expose the first drain electrode TD1 of the first thin film transistor ST1. The first anode connection electrode ANDE1 may be formed as a single layer or a multi-layer made of any one of molybdenum (Mo), aluminum (Al), chromium (Cr), gold (Au), titanium (Ti), nickel (Ni), neodymium (Nd), and copper (Cu), or an alloy thereof.

In an embodiment, the first organic film 160 for planarization may be disposed on the first pixel connection electrode ANDE1. The first organic film 160 may be formed as an organic film made of an acryl resin, an epoxy resin, a phenolic resin, a polyamide resin, a polyimide resin, or the like.

In an embodiment, the second anode connection electrode ANDE2 may be disposed on the first organic film 160. The second anode connection electrode ANDE2 may be connected to the first anode connection electrode ANDE1 through a second anode contact hole ANCT2 penetrating through the first organic film 160 to expose the first anode connection electrode ANDE1. The second anode connection electrode ANDE2 may be formed as a single layer or a multi-layer made of any one of molybdenum (Mo), aluminum (Al), chromium (Cr), gold (Au), titanium (Ti), nickel (Ni), neodymium (Nd), and copper (Cu), or an alloy thereof.

In an embodiment, the second organic film 180 may be disposed on the second anode connection electrode ANDE2. The second organic film 180 may be formed as an organic film made of an acryl resin, an epoxy resin, a phenolic resin, a polyamide resin, a polyimide resin, or the like.

In an embodiment and as illustrated in FIG. 4, the first thin film transistor ST1 is formed in a top gate type in which the first gate electrode TG1 is positioned above the first active layer ACT1, but the invention is not limited thereto. The first thin film transistor ST1 may be formed in a bottom gate type in which the first gate electrode TG1 is positioned below the first active layer ACT1 or a double gate type in which the first gate electrode TG1 is positioned both above and below the first active layer ACT1.

In an embodiment, the light emitting element layer EML may be disposed on the second organic film 180. The light emitting element layer EML may include light emitting elements 170 and a bank 190. Each of the light emitting elements 170 may include a first light emitting electrode 171, a light emitting layer 172, and a second light emitting electrode 173.

In an embodiment, the first light emitting electrode 171 may be formed on the second organic film 180. The first light emitting electrode 171 may be connected to the second anode connection electrode ANDE2 through a third anode contact hole ANCT3 penetrating through the second organic film 180 to expose the second anode connection electrode ANDE2.

In an embodiment, the first light emitting electrode 171 may be formed on the second organic film 180. The first light emitting electrode 171 may be connected to the second anode connection electrode ANDE2 through a third anode contact hole ANCT3 penetrating through the second organic film 180 to expose the second anode connection electrode ANDE2.

In an embodiment, in a top emission structure in which light is emitted toward the second light emitting electrode 173 based on the light emitting layer 172, the first light emitting electrode 171 may be formed of a metal material having high reflectance, such as a stacked structure (Ti/Al/Ti) of aluminum and titanium, a stacked structure (ITO/Al/ITO) of aluminum and indium tin oxide (ITO), an APC alloy, and a stacked structure (ITO/APC/ITO) of an APC alloy and ITO. The APC alloy is an alloy of silver (Ag), palladium (Pd), and copper (Cu).

In an embodiment, the bank 190 may be formed to partition the first light emitting electrode 171 on the second organic film 180 to define a light emitting area EA. The bank 190 may be formed to cover an edge of the first light emitting electrode 171. The bank 190 may be formed as an organic film such as an acrylic resin, an epoxy resin, a phenolic resin, a polyamide resin, or a polyimide resin.

In an embodiment, the light emitting area EA refers to an area in which the first light emitting electrode 171, the light emitting layer 172, and the second light emitting electrode 173 are sequentially stacked and holes from the first light emitting electrode 171 and electrons from the second light emitting electrode 173 are combined with each other in the light emitting layer 172 to emit light.

In an embodiment, the light emitting layer 172 is formed on the first light emitting electrode 171 and the bank 190. The light emitting layer 172 may include an organic material to emit light of a predetermined color. For example, the light emitting layer 172 may include a hole transporting layer, an organic material layer, and an electron transporting layer.

In an embodiment, the second light emitting electrode 173 may be disposed on the light emitting layer 172. The second light emitting electrode 173 may be formed to cover the light emitting layer 172. The second light emitting electrode 173 may be a common layer commonly formed in all the light emitting areas EA. Although not illustrated, in an embodiment, a capping layer may be formed on the second light emitting electrode 173.

In an embodiment, in the top emission structure, the second light emitting electrode 173 may be formed of transparent conductive oxide (TCO) such as indium tin oxide (ITO) or indium zinc oxide (IZO) capable of transmitting light, or a semi-transmissive conductive material such as magnesium (Mg), silver (Ag), or an alloy of magnesium (Mg) and silver (Ag). When the second light emitting electrode 173 is formed of the semi-transmissive conductive material, light emission efficiency may be increased by a micro cavity.

In an embodiment, the thin film encapsulation layer TFEL may be disposed on the second light emitting electrode 173. The thin film encapsulation layer TFEL may include at least one inorganic film to prevent oxygen or moisture from permeating into the light emitting element layer. In addition, the thin film encapsulation layer TFEL may include at least one organic film to protect the light emitting element layer from foreign substances such as dust. For example, the thin film encapsulation layer TFEL may include a first encapsulation film TFE1, a second encapsulation film TFE2, and a third encapsulation film TFE3.

In an embodiment, the first encapsulation film TFE1 (e.g., a first inorganic encapsulation film) may be disposed on the second light emitting electrode 173. The first encapsulation film TFE1 may be an inorganic film of a single layer or a multi-layer. The first encapsulation film TFE1 may be formed as a multi-film or a single film in which one or more inorganic films of a silicon nitride layer, a silicon oxynitride layer, a silicon oxide layer, a titanium oxide layer, and an aluminum oxide layer are alternately stacked.

In an embodiment, the second encapsulation film TFE2 (e.g., a first organic encapsulation film) may be disposed on the first encapsulation film TFE1. The second encapsulation film TFE2 may be an organic film of a single layer or a multi-layer. The second encapsulation film TFE2 may include a polymer-based material. Examples of the polymer-based material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, etc.), or any combination thereof.

In an embodiment, the third encapsulation film TFE3 (e.g., a second inorganic encapsulation film) may be disposed on the second encapsulation film TFE2. The third encapsulation film TFE3 may be an inorganic film of a single layer or a multi-layer. The third encapsulation film TFE3 may include the same material as the first encapsulation film TFE1. For example, the third encapsulation film TFE3 may be formed as a multi-film or a single film in which one or more inorganic films of a silicon nitride layer, a silicon oxynitride layer, a silicon oxide layer, a titanium oxide layer, and an aluminum oxide layer are alternately stacked.

In an embodiment, the touch sensor layer TSU may be disposed on the thin film encapsulation layer TFEL. The touch sensor layer TSU may include a plurality of touch electrodes for sensing a user's touch in a capacitance method, and touch lines connecting the plurality of touch electrodes and the touch driver. For example, the touch sensor layer TSU may sense the user's touch in a mutual capacitance method or a self-capacitance method.

In another embodiment, the touch sensor layer TSU may be disposed on a separate substrate disposed on the display layer DU. In this case, the substrate supporting the touch sensor layer TSU may be an encapsulation member that encapsulates the display layer DU.

In an embodiment, the plurality of touch electrodes of the touch sensor layer TSU may be disposed in a touch sensor area overlapping the display area. The touch lines of the touch sensor layer TSU may be disposed in a touch peripheral area overlapping the non-display area.

In an embodiment, the touch sensor layer TSU may include a first touch insulating film SIL1, a first touch electrode REL, a second touch insulating film SIL2, a second touch electrode TEL, and a third touch insulating film SIL3.

In an embodiment, the first touch insulating film SIL1 may be disposed on the thin film encapsulation layer TFEL. The first touch insulating film SIL1 may have insulation and optical functions. The first touch insulating film SIL1 may include at least one inorganic film. For example, the first touch insulating film SIL1 may be an inorganic film including at least one of a silicon nitride layer, a silicon oxynitride layer, a silicon oxide layer, a titanium oxide layer, and an aluminum oxide layer. In another embodiment, the first touch insulating film SIL1 may be omitted.

In an embodiment, the first touch electrode REL may be disposed on the first touch insulating film SIL1. The first touch electrode REL may not overlap the light emitting element 170. The first touch electrode REL may be formed as a single layer made of molybdenum (Mo), titanium (Ti), copper (Cu), aluminum (Al), or indium tin oxide (ITO), or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

In an embodiment, the second touch insulating film SIL2 may cover the first touch electrode REL and the first touch insulating film SIL1. The second touch insulating film SIL2 may have insulation and optical functions. For example, the second touch insulating film SIL2 may be made of the materials illustrated in the first touch insulating film SIL1.

In an embodiment, the second touch electrode TEL may be disposed on the second touch insulating film SIL2. The second touch electrode TEL may not overlap the light emitting element 170. The second touch electrode TEL may be formed as a single layer made of molybdenum (Mo), titanium (Ti), copper (Cu), aluminum (Al), or indium tin oxide (ITO), or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

In an embodiment, the third touch insulating film SIL3 may cover the second touch electrode TEL and the second touch insulating film SIL2. The third touch insulating film SIL3 may have insulation and optical functions. The third touch insulating film SIL3 may be made of the materials illustrated in the second touch insulating film SIL2.

In some embodiments, the first touch insulating film SIL1, the second touch insulating film SIL2, and the third touch insulating film SIL3 may be organic films. For example, the first touch insulating film SII,1, the second touch insulating film SIL2, and the third touch insulating film SIL3 may be organic films made of an acryl resin, an epoxy resin, a phenolic resin, a polyamide resin, a polyimide resin, or the like.

In an embodiment, the touch sensor layer TSU may further include a planarization film PAS for planarization. The planarization film PAS may be formed as an organic film made of an acrylic resin, an epoxy resin, a phenolic resin, a polyamide resin, a polyimide resin, or the like.

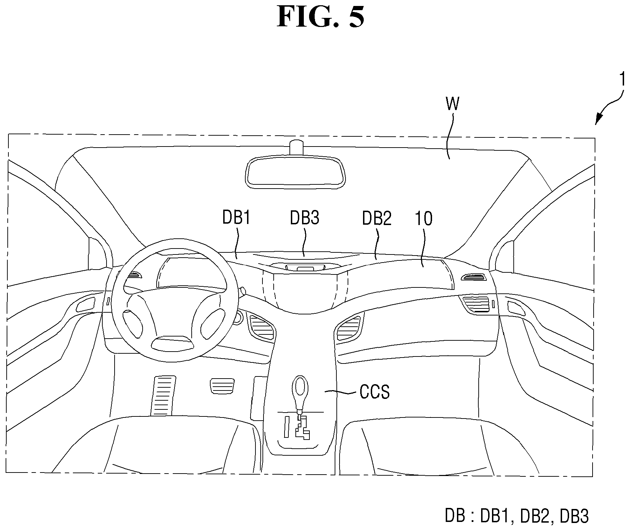

FIG. 5 is a perspective view illustrating an example of an electronic device, according to an embodiment.

In an embodiment and referring to FIG. 5, an electronic device 1 may refer to any electronic device that provides a display screen. In FIG. 5, a car is illustrated as an example of the electronic device 1, but the invention is not limited thereto.

In an embodiment, the electronic device 1 may include a display device 10 that provides a display screen. In some embodiments, when the electronic device 1 is a vehicle, the display device 10 may be a vehicle display. The vehicle display may provide users with various service information such as convenience functions, media information, etc., as well as information about vehicle operation information and status information. When the display device 10 includes an input device such as a touch panel, the user may manipulate various functions such as a driving mode of the vehicle and convenience functions through the display device 10.

In some embodiments, the display device 10 may have a shape extending in a first direction. In another embodiment, when the display device 10 is also disposed on a center console CCS, the display device 10 may have a shape extending in a first direction and a second direction different from the first direction.

In an embodiment, a shape of the electronic device 1 may be variously changed. For example, as illustrated in FIG. 5, when the electronic device 1 is a vehicle, the electronic device 1 may include a vehicle body that forms an exterior of the vehicle, and an interior space defined by the vehicle body. As illustrated in FIG. 4, the display device 10 may be provided in the interior space. In some embodiments, the electronic device 1 may include a dashboard DB, a center console CCS, and a windshield W.

In an embodiment, the dashboard DB may provide various information about a vehicle infotainment system to a driver and other passengers. The vehicle infotainment system refers to a system that provides information and entertainment to the driver and other passengers by integrating in-vehicle and external systems. The vehicle infotainment system may include devices or technologies that search the Internet inside the vehicle and provide various services linked to movies, games, television (TV), social networking services (SNS), navigation, and mobile devices.

In an embodiment, the dashboard DB may include a first dashboard DB 1 disposed in front of a driver's seat, a second dashboard DB2 disposed in front of a passenger seat, and a third dashboard DB3 disposed between the first dashboard DB1 and the second dashboard.

In an embodiment, the first dashboard DB 1 may include an instrument panel and provide the driver with various information necessary for driving, such as speed information and vehicle status information. In an embodiment, the first dashboard DB 1 may include a digital cluster or an instrument cluster display.

In an embodiment, the third dashboard DB3 may provide map information, music information, temperature information, etc. The third dashboard DB3 may provide various functions capable of manipulating convenience functions that help drive the vehicle. As an example, the third dashboard DB3 may include a center information display.

In an embodiment, the second dashboard DB2 may provide the information of the first dashboard DB1 and the third dashboard DB3 to the passenger in the passenger seat. As an example, the second dashboard DB2 may include a co-driver display.

In an embodiment, the center console CCS may be disposed below the third dashboard DB3. The center console CCS may be disposed between the driver's seat and the passenger seat. Although not illustrated in the drawing, the display device 10 may also be disposed on the center console CCS.

In an embodiment, the center console CCS may include various functional members for controlling a driving method of the vehicle, such as a gear lever, a parking brake, and a driving mode manipulation button. In an embodiment, it is illustrated as an example that the gear lever, etc. is an analog type that operates by physical manipulation, but the invention is not limited thereto. For example, as the display device 10 disposed on the center console CCS includes an input device such as a touch panel, the gear lever, etc. may also be a digital type that operates through manipulation buttons output on the display device 10.

In an embodiment, the information provided from the first to third dashboards DB1, DB2, and DB3, respectively, and the center console CCS is not provided by being limited to any one of the first to third dashboards DB1, DB2, and DB3, respectively, and the center console CCS, and information provided from any one of the first to third dashboards DB1, DB2, and DB3, respectively and the center console CCS may also be provided from other configurations.

In an embodiment, the electronic device 1 may provide various information to the user through the display device 10 disposed on the first to third dashboards DB1, DB2, and DB3, respectively, and the center console CCS, or may manipulate other configurations included in the electronic device 1 based on information input by the user through the display device 10.

In an embodiment, the windshield W may be disposed above the dashboard DB. The windshield W may protect the driver and passengers from the outside and provide visibility to the driver.

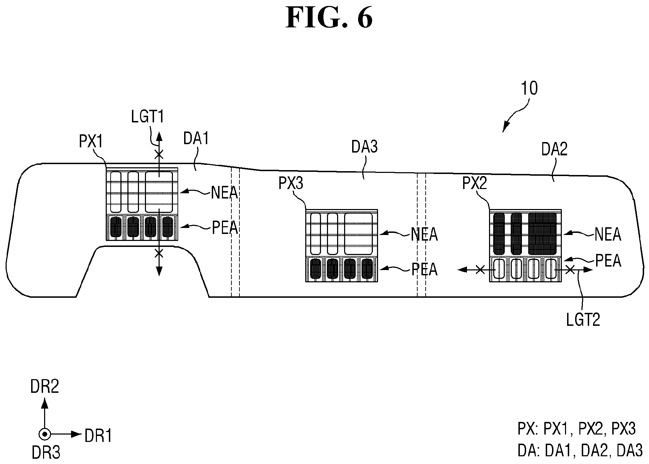

FIG. 6 is a plan view illustrating an example of the display device, according to an embodiment.

In an embodiment and referring to FIGS. 5 and 6, the display area DA of the display device 10 may include first to third display areas DA1, DA2, and DA3, respectively.

In an embodiment, the first display area DA1 may be disposed on the first dashboard DB1, the second display area DA2 may be disposed on the second dashboard DB2, and the third display area DA3 may be disposed on the third dashboard DB3. The first display area DA1, the second display area DA2 and the third display area DA3 may include first to third pixels PX1, PX2, and PX3, respectively.

In an embodiment, the first to third pixels PX1, PX2, and PX3, respectively, may each include a normal mode area NEA (e.g., a first light emitting mode area) and a privacy mode area PEA (e.g., a second light emitting mode area). In the drawing, the normal mode area NEA is illustrated as being disposed on the privacy mode area PEA, but the invention is not limited thereto.

In an embodiment, when the user drives the display device 10 in a normal mode, the light emitting element disposed in the normal mode area NEA may emit light, and the light emitting element disposed in the privacy mode area PEA may not emit light. When the user drives the display device 10 in a privacy mode, the light emitting element disposed in the normal mode area NEA may not emit light, and the light emitting element disposed in the privacy mode area PEA may emit light.

In an embodiment and referring to FIG. 6, it is illustrated as an example that the first pixel PX1 of the first display area DA1 and the third pixel PX3 of the third display area DA3 operate in the normal mode, and the second pixel PX2 of the second display area DA2 operates in the privacy mode.

In an embodiment, in a conventional display device 10, some of the light emitted from the display device 10 may be reflected on the surrounding windshield W and provided to the driver. In this case, an image displayed on the windshield W may interfere with the driver's driving. In addition, some of the light emitted from the first display area DA1 in front of the driver's seat moves toward the passenger seat, or some of the light emitted from the second display area DA2 in front of the passenger seat may move toward the driver's seat. In this case, the display device 10 may be vulnerable to privacy protection.

In an embodiment and referring to the display device 10, the driver may recognize (or visually recognize) the display screen of the display device 10 through the light emitted from the normal mode area NEA or the privacy mode area PEA. In this case, the display device 10 may adjust a viewing angle of the light emitted from the display device 10 in a frontal direction (a direction directly facing the driver).

In an embodiment, as a vertical viewing angle is adjusted in the normal mode area NEA, it is possible to prevent in advance first light LGT1 emitted from the normal mode area NEA from being reflected on the surrounding windshield W and being provided to the driver.

In an embodiment, as a horizontal viewing angle is adjusted in the privacy mode area PEA, privacy protection may be strengthened by preventing second light LGT2 emitted from the privacy mode area PEA of the first display area DA1 in front of the driver's seat from being provided to the passenger, or second light LGT2 emitted from the privacy mode area PEA of the second display area DA2 in front of the passenger seat from being provided to the driver.

In an embodiment, the viewing angle may be adjusted through the light control layer LCL (see FIG. 7). The viewing angle may be limited to a predetermined angular range through the light control layer LCL (see FIG. 7). As an example, when a virtual line facing the driver in front and extending in a direction (e.g., a third direction DR3) perpendicular to a display surface of the display device 10 is taken as a normal line, the viewing angle may be an angle within about 35° from the normal line. In some embodiments, the angle within about 35° from the normal line may be defined as an effective viewing angle, but is not limited thereto.

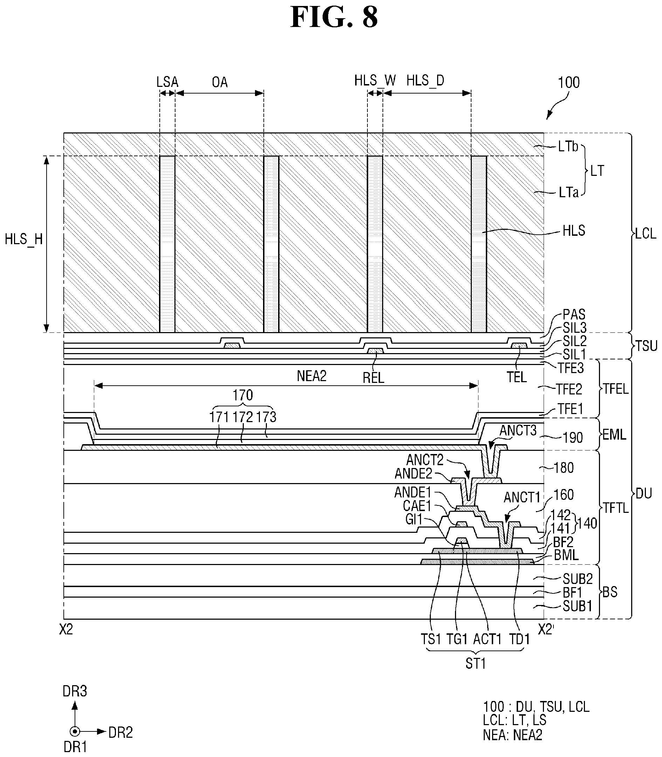

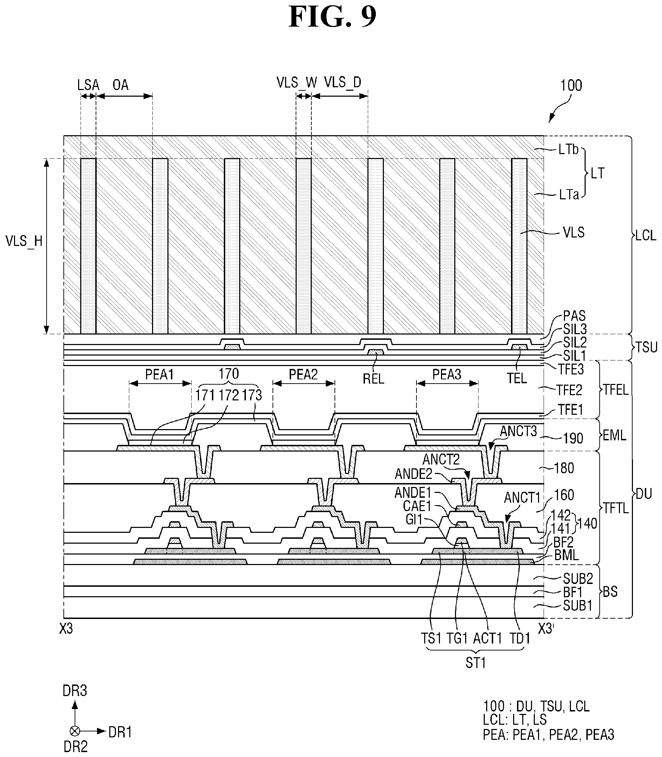

FIG. 7 is a plan view illustrating a pixel and a light control layer of the display device, according to an embodiment. FIG. 8 is a cross-sectional view taken along line X2-X2' of FIG. 7, according to an embodiment. FIG. 9 is a cross-sectional view taken along line X3-X3' of FIG. 7, according to an embodiment.

In an embodiment and referring to FIGS. 7 to 9, each pixel PX may include a plurality of light emitting areas EA. The light emitting area EA may be an area where the light generated from the light emitting element is emitted to the outside.

In an embodiment, the plurality of light emitting areas EA may be defined by the bank 190. For example, the plurality of light emitting areas EA may be areas that overlap the light emitting layer 172 disposed within the opening of the bank 190. The light emitting area EA may be an area where the first light emitting electrode 171, the light emitting layer 172, and the second light emitting electrode 173 are sequentially stacked while overlapping each other.

In some embodiments, the plurality of light emitting areas EA may include a normal mode area NEA and a privacy mode area PEA. The normal mode area NEA and the privacy mode area PEA may include first to third light emitting areas NEA1, NEA2, NEA3, PEA1, PEA2, and PEA3, respectively.

In an embodiment, the normal mode area NEA and the privacy mode area PEA are illustrated as each including three types of light emitting areas EA, but the invention is not limited thereto. For example, the normal mode area NEA and the privacy mode area PEA may each include fewer or more than three types of light emitting areas EA. In addition, it is illustrated in the drawing that the normal mode area NEA includes one each of the first to third light emitting area NEA1, NEA2, and NEA3, respectively, and the privacy mode area PEA includes one each of the first and second light emitting areas PEA1 and PEA2, respectively, and two third light emitting areas PEA3, but the invention is not limited thereto.

In some embodiments, the first light emitting areas NEA1 and PEA1 may emit light of a first color, the second light emitting areas NEA2 and PEA2 may emit light of a second color, and the third light emitting areas NEA3 and PEA3 may emit light of a third color. The light of the first color may be light in a red wavelength band, the light of the second color may be light in a green wavelength band, and the light of the third color may be light in a blue wavelength band. The red wavelength band may be a wavelength band of approximately 600 nm to about 750 nm, the green wavelength band may be a wavelength band of approximately 480 nm to about 560 nm, and the blue wavelength band may be a wavelength band of approximately 370 nm to about 460 nm, but the invention is not limited thereto.

The first to third light emitting areas NEA1, PEA1, NEA2, PEA2 and NEA3, PEA3, respectively, may each have a rectangular, square, or diamond planar shape. For example, as illustrated in the drawing, the first to third light emitting areas NEA1, PEA1, NEA2, NEAD2 and NEA3, PEA3, respectively, may have a rectangular shape, but are not limited thereto.

In an embodiment, areas of the first to third light emitting areas NEA1,PEA1, NEA2, PEA2 and NEA3, PEA3, respectively, may be different from each other. For example, as in the normal mode area NEA in the drawing, the area of the third light emitting area NEA3 may be greater than the areas of the first and second light emitting areas NEA1 and NEA2, respectively, but is not limited thereto.

In another embodiment, areas of the first to third light emitting areas NEA1, PEA1, NEA2, PEA2 and NEA3, PEA3 may be the same as each other. For example, as in the privacy mode area PEA in the drawing, the areas of the first to third light emitting areas PEA1, PEA2, and PEA3, respectively, may be the same as each other, but are not limited thereto.

In an embodiment, without being limited to what is illustrated in the drawing, the areas of the first to third light emitting areas NEA1, NEA2, and NEA3, respectively, in the normal mode area NEA may be the same as each other, and the areas of the first to third light emitting areas PEA1, PEA2, and PEA3, respectively, in the privacy mode area PEA may be different from each other.

In some embodiments, the first to third light emitting areas NEA1, PEA1, NEA2, PEA2 and NEA3, PEA3, respectively, may be disposed side by side along the first direction DR1. For example, in the normal mode area NEA, the first to third light emitting areas NEA1, NEA2, and NEA3, respectively, may be disposed in that order along the first direction DR1, and in the privacy mode area PEA, the first to third light emitting areas PEA1, PEA2, and PEA3, respectively, may be disposed in that order along the first direction DR1.

In another embodiment, the first to third light emitting areas NEA1, PEA1, NEA2, PEA2 and NEA3, PEA3, respectively, may be disposed side by side along the second direction DR2. In still another embodiment, the first to third light emitting areas NEA1, PEA1, NEA2, PEA2 and NEA3, PEA3, respectively, may also be disposed to overlap in both the first direction DR1 and the second direction DR2. That is, the arrangement of the first to third light emitting areas NEA1, PEA1, NEA2, PEA2 and NEA3 PEA3 may be modified in various ways.

In an embodiment, a case in which the first to third light emitting areas NEA1, PEA1, NEA2, PEA2, and NEA3, PEA3, respectively, are disposed side by side along the first direction DR1 will be described as an example.

In an embodiment, the light emitting areas EA may overlap the transmissive area OA and the non-transmissive area LSA in the third direction DR3. For example, the first to third light emitting areas NEA1, PEA1, NEA2, PEA2 and NEA3, PEA3, respectively, may overlap the transmissive area OA and the non-transmissive area LSA in the third direction DR3.

In an embodiment, the transmissive area OA may be an area where the plurality of light blocking films LS of the light control layer LCL is not disposed. The non-transmissive area LSA may be an area where the plurality of light blocking films LS of the light control layer LCL is disposed.

An embodiment is illustrated in the drawing as an example that in the normal mode area NEA, the transmissive area OA and the non-transmissive area LSA extend in the first direction DR1, and in the privacy mode area PEA, the transmissive area OA and the non-transmissive area LSA extend in the second direction DR2. The direction of extension of the transmissive area OA and the non-transmissive area LSA is not limited thereto, but for convenience of explanation, a case in which in the normal mode area NEA, the transmissive area OA and the non-transmissive area LSA extend in the first direction DR1, and in the privacy mode area PEA, the transmissive area OA and the non-transmissive area LSA extend in the second direction DR2 will be described as an example.

In some embodiments, in the normal mode area NEA, the transmissive area OA and the non-transmissive area LSA may extend along the first direction DR1 and may be disposed to alternate with each other in the second direction DR2. In the privacy mode area PEA, the transmissive area OA and the non-transmissive area LSA may extend along the second direction DR2 and may be disposed to alternate with each other in the first direction DR1.

In an embodiment and as illustrated in FIGS. 8 and 9, the light control layer LCL may be disposed on the display layer DU or the touch sensor layer TSU. The light control layer LCL may control a viewing angle of light emitted from the light emitting layer 172. For example, when light emitted from the light emitting layer 172 travels at a predetermined angle or less with respect to the third direction DR3, the light may be emitted to the outside. On the other hand, when the light emitted from the light emitting layer 172 travels beyond a predetermined angle with respect to the third direction DR3, the light may be absorbed or blocked by the plurality of light blocking films LS and not emitted to the outside.

In an embodiment, the light control layer LCL may include a light transmitting film LT and a plurality of light blocking films LS.

In an embodiment, the plurality of light blocking films LS may be disposed on the touch sensor layer TSU. The plurality of light blocking films LS may be disposed in the non-transmissive area LSA. The plurality of light blocking films LS may absorb or block the light emitted from the light emitting layer 172. The plurality of light blocking films LS may include a light blocking organic material. For example, the plurality of light blocking films LS may include an organic material including an organic black pigment such as carbon black, as a photosensitive resin capable of absorbing or blocking light.

In an embodiment, the plurality of light blocking films LS may extend in different directions in the normal mode area NEA and the privacy mode area PEA. For example, the plurality of light blocking films LS may extend along the first direction DR1 in the normal mode area NEA and may extend along the second direction DR2 in the privacy mode area PEA. The plurality of light blocking films LS may include a plurality of horizontal light blocking films HLS disposed in the normal mode area NEA and extending in the first direction DR1, and a plurality of vertical light blocking films VLS disposed in the privacy mode area PEA and extending in the second direction DR2.

In the present specification, the horizontal and vertical directions of the plurality of horizontal light blocking films HLS and the plurality of vertical light blocking films VLS may refer to the first direction DR1 and the second direction DR2, respectively, in the drawing, but this is only specified as an example for convenience of explanation, and in an embodiment, the direction of extension of the plurality of light blocking films LS is not limited to the horizontal and vertical directions.

In an embodiment, in the normal mode area NEA, the plurality of horizontal light blocking films HLS may be disposed to be spaced apart from each other along the second direction DR2. In the privacy mode area PEA, the plurality of vertical light blocking films VLS may be disposed to be spaced apart from each other along the first direction DR1.

In an embodiment, the display device 10 may adjust and change a vertical viewing angle and a horizontal viewing angle depending on the driving type by including the plurality of light blocking films LS extending in different directions in the normal mode area NEA and the privacy mode area PEA.

In some embodiments, as illustrated in FIG. 7, at a boundary between the normal mode area NEA and the privacy mode area PEA, the plurality of horizontal light blocking films HLS and the plurality of vertical light blocking films VLS may be connected to each other, but are not limited thereto.

In an embodiment, the light transmitting film LT may be disposed on the display layer DU or the touch sensor layer TSU. The light transmitting film LT may be disposed in the transmissive area OA and the non-transmissive area. The light transmitting film LT may transmit the light emitted from the light emitting layer 172. The light transmitting film LT may include a transparent organic material. For example, the light transmitting film LT may be an organic film made of an acryl resin, an epoxy resin, a phenolic resin, a polyamide resin, a polyimide resin, or the like. In another embodiment, the light transmitting film LT may include silicon oxynitride or silicon oxide.

In some embodiments, the light transmitting film LT may extend along the first direction DR1 in the normal mode area NEA and may extend along the second direction DR2 in the privacy mode area PEA. For example, the light transmitting film LT may be disposed between the plurality of horizontal light blocking films HLS in the normal mode area NEA and may be disposed between the plurality of vertical light blocking films VLS in the privacy mode area PEA.

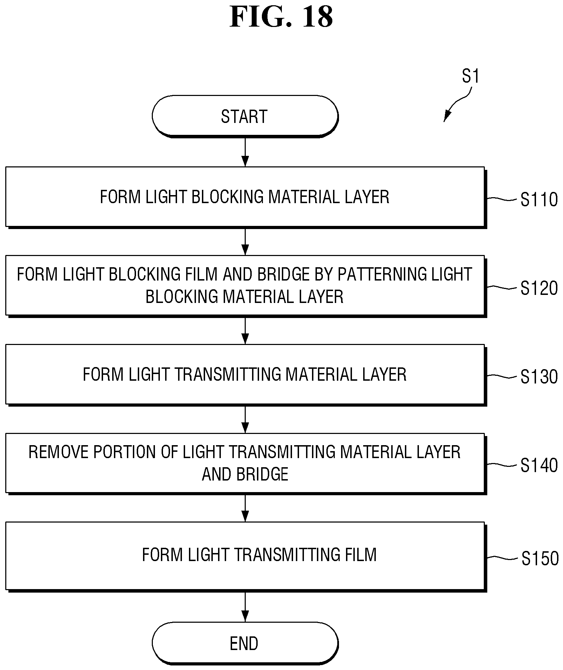

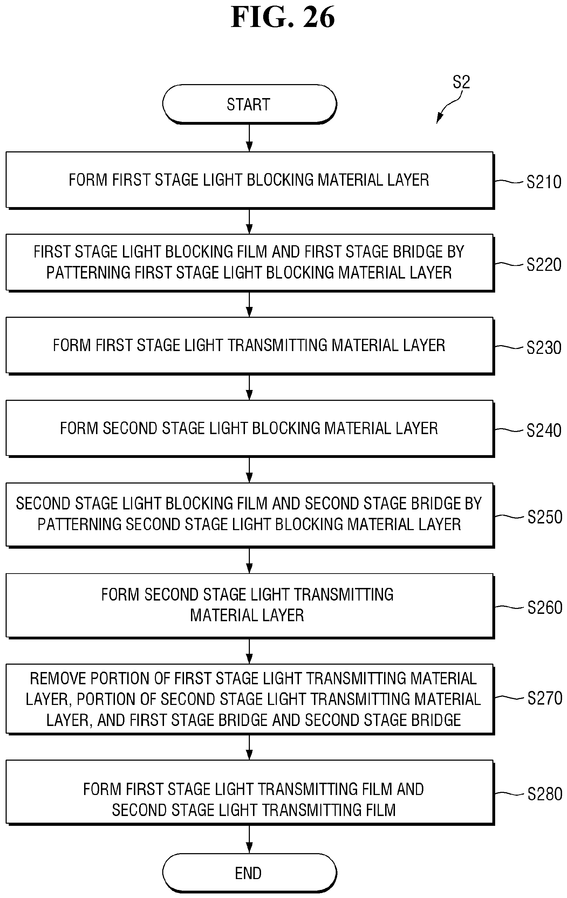

In some embodiments, the light transmitting film LT may be formed later than the plurality of light blocking films LS by first applying a material for forming the plurality of light blocking films LS to perform a patterning, and then applying a material for forming the light transmitting film LT, as in methods S1 and S2 for manufacturing a display device described later (see FIGS. 18 and 26).

In an embodiment, compared to a case in which the material for forming the light transmitting film LT is first applied and patterned, and then the material for forming the plurality of light blocking films LS is applied, a side profile of the plurality of light blocking films LS may have excellent characteristics. For example, by first applying the material for forming the plurality of light blocking films LS to perform the patterning, and then applying the material for forming the light transmitting film LT, the side profile of the plurality of light blocking films LS may be formed to be close to about 90 degrees, or may be formed in a normal-tapered shape where an upper portion is narrower than a lower portion. As the side profile of the plurality of light blocking films LS is formed to be close to about 90 degrees, or is formed in the normal-tapered shape where the upper portion is narrower than the lower portion, viewing angle control and luminance characteristics may be improved.

In addition, when the material for forming the light transmitting film LT is first applied and patterned, and then the material for forming the plurality of light blocking films LS is applied, an additional polishing process such as a chemical mechanical polishing (CMP) process needs to be performed to remove the plurality of light blocking films LS excessively applied onto an upper surface of the light transmitting film LT. On the other hand, as in the display device 10, when the material for forming the plurality of light blocking films LS is first applied to perform the patterning, and then the material for forming the light transmitting film LT is applied, process efficiency may be improved because there is no need to remove the light transmitting film LT excessively applied onto the plurality of light blocking films LS.

In an embodiment, as illustrated in FIGS. 8 and 9, the light transmitting film LT may include a first portion LTa and a second portion LTb.

In an embodiment, the first portion LTa of the light transmitting film LT may be disposed between the plurality of light blocking films LS. The first portion LTa of the light transmitting film LT may be disposed in the transmissive area OA. For example, the first portion LTa of the light transmitting film LT may be positioned at the same height as the plurality of light blocking films LS in the third direction DR3. The height of the first portion LTa of the light transmitting film LT may be the same as the height of the plurality of light blocking films LS.

In an embodiment, the second portion LTb of the light transmitting film LT may be disposed on the plurality of light blocking films LS and the first portion LTa of the light transmitting film LT. The second portion LTb of the light transmitting film LT may be disposed in the transmissive area OA and the non-transmissive area LSA. The second portion LTb of the light transmitting film LT may be disposed on the entire surface of the plurality of light blocking films LS and the first portion LTa of the light transmitting film LT.

In an embodiment, when the material for forming the plurality of light blocking films LS is first applied to perform the patterning and then the material for forming the light transmitting film LT is applied as described above, the second portion LTb of the light transmitting film LT may be formed when the material for forming the light transmitting film LT is excessively applied onto the plurality of light blocking films LS. In another embodiment, the second portion LTb of the light transmitting film LT may also be omitted.

In an embodiment, widths HLS_W and VLS_W of the plurality of light blocking films LS may be smaller than distances HLS_D and VLS_D between the plurality of light blocking films LS. The distances HLS_D and VLS_D between the plurality of light blocking films LS may be about 2 to about 10 times the widths HLS_W and VLS_W of the plurality of light blocking films LS. For example, the widths HLS_W and VLS_W of the plurality of light blocking films LS may be approximately 1 *µ*m to about 20 *µ*m, and the distances HLS_D and VLS_D between the plurality of light blocking films LS may be about 5 *µ*m to about 100 *µ*m, but are not limited thereto.

In an embodiment, the width HLS_W of the plurality of horizontal light blocking films HLS and the width VLS _W of the plurality of vertical light blocking films VLS may be variously modified depending on the arrangement of the pixels, for example, the arrangement of the first to third light emitting areas NEA1, PEA1, NEA2, PEA2 and NEA3, PEA3, respectively. For example, as illustrated in the drawing, the width HLS_W of the plurality of horizontal light blocking films HLS and the width VLS_W of the plurality of vertical light blocking films VLS are illustrated as being the same, but are not limited thereto.

In an embodiment, the distance HLS _D of the plurality of horizontal light blocking films HLS and the distance VLS_D of the plurality of vertical light blocking films VLS may be variously modified depending on the arrangement of the pixels, for example, the arrangement of the first to third light emitting areas NEA1, PEA1, NEA2, PEA2 and NEA3, PEA3, respectively. For example, the distance HLS_D between the plurality of horizontal light blocking films HLS is shown as being greater than the distance VLS_D between the plurality of vertical light blocking films VLS, but is not limited thereto.

In an embodiment, as illustrated in FIGS. 8 and 9, heights HLS_H and VLS_H of the plurality of light blocking films LS may be greater than the widths HLS_W and VLS_W of the plurality of light blocking films LS. For example, the heights HLS_H and VLS_H of the plurality of light blocking films LS may be about 5 to about 20 times the widths HLS_W and VLS_W of the plurality of light blocking films LS. As the heights HLS_H and VLS_H of the plurality of light blocking films LS increases, the viewing angle control characteristics of the display device 10 may be improved, and as the widths HLS_W and VLS_W of the plurality of light blocking films LS becomes narrower, the luminance of the display device 10 may be improved.

Other embodiments of the display device will be described. In the following embodiments, the same components as those of the above-described embodiment will be denoted by the same reference numerals, and an overlapping description thereof will be omitted or simplified and differences will be mainly described.

FIG. 10 is a plan view illustrating a pixel and a light control layer of a display device, according to another embodiment.

In an embodiment and referring to FIG. 10, a display device 10 is different from the display device 10 according to the embodiment described with reference to FIG. 7 and the like in that the plurality of light blocking films LS further includes a bridge BLG.

More specifically, in an embodiment, the plurality of light blocking films LS may further include a bridge BLG.

In an embodiment, the bridge BLG may support the plurality of horizontal light blocking films HLS and the plurality of vertical light blocking films VLS. In some embodiments, the bridge BLG may include the same material as the plurality of light blocking films LS. For example, the bridge BLG may include the same material as the plurality of horizontal light blocking films HLS and the plurality of vertical light blocking films VLS. The bridge BLG may connect between the plurality of horizontal light blocking films HLS and between the plurality of vertical light blocking films VLS. For example, the bridge BLG may include a vertical bridge VBL connecting between the plurality of horizontal light blocking films HLS, and a horizontal bridge HBL connecting between the plurality of vertical light blocking films VLS.

In the present specification, the horizontal and vertical directions of the horizontal bridge HBL and the vertical bridge VBL may refer to the first direction DR1 and the second direction DR2, respectively, in the drawing, but this is only specified as an example for convenience of explanation, and the direction of extension of the bridge BLG is not limited to the horizontal and vertical directions.

In an embodiment, in the normal mode area NEA, the vertical bridge VBL may extend in the second direction DR2. The vertical bridge VBL may connect the plurality of horizontal light blocking films HLS disposed to be spaced apart from each other along the second direction DR2.

In an embodiment, in the privacy mode area PEA, the horizontal bridge HBL may extend in the first direction DR1. The horizontal bridge HBL may connect the plurality of vertical light blocking films VLS disposed to be spaced apart from each other along the first direction DR1.

In an embodiment, the display device 10 includes the bridge BLG, thereby preventing the plurality of light blocking films LS from collapsing during a patterning process of the plurality of light blocking films LS in the methods S1 and S2 for manufacturing the display device described later. For example, as described above with reference to FIGS. 8 and 9, the width of the plurality of light blocking films LS may be very small compared to the height of the plurality of light blocking films LS. Therefore, when the material for forming the plurality of light blocking films LS is first applied to perform the patterning and then the material for forming the light transmitting film LT is applied, the plurality of light blocking films LS may collapse in a direction different from the direction of extension thereof due to the thin width compared to the height. In the display device 10 according to an embodiment, the plurality of light blocking films LS includes the bridge BLG, thereby preventing the plurality of light blocking films LS from collapsing.

In an embodiment, in the display device 10, the bridge BLG may not overlap the light emitting area EA. Accordingly, the luminance of the display device 10 may be improved, and the viewing angle characteristics of the display device 10 may be improved. For example, as the bridge BLG does not overlap the light emitting area EA, a decrease in luminance in the first direction DR1 may be prevented in the normal mode area NEA, and a decrease in luminance in the second direction DR2 may be prevented in the privacy mode area PEA.

In an embodiment, widths VBL_W and HBL_W of the vertical bridge VBL and the horizontal bridge HBL may be different from the widths HLS_W and VLS_W of the plurality of horizontal light blocking films HLS and the plurality of vertical light blocking films VLS. For example, the widths VBL_W and HBL_W of the vertical bridge VBL and the horizontal bridge HBL may be greater than the widths HLS_W and VLS _W of the plurality of horizontal light blocking films HLS and the plurality of vertical light blocking films VLS. Accordingly, at the same time as minimizing the decrease in luminance of the display device 10, a support force of the vertical bridge VBL and the horizontal bridge HLBL with respect to the plurality of horizontal light blocking films HLS and the plurality of vertical light blocking films VLS may be improved.

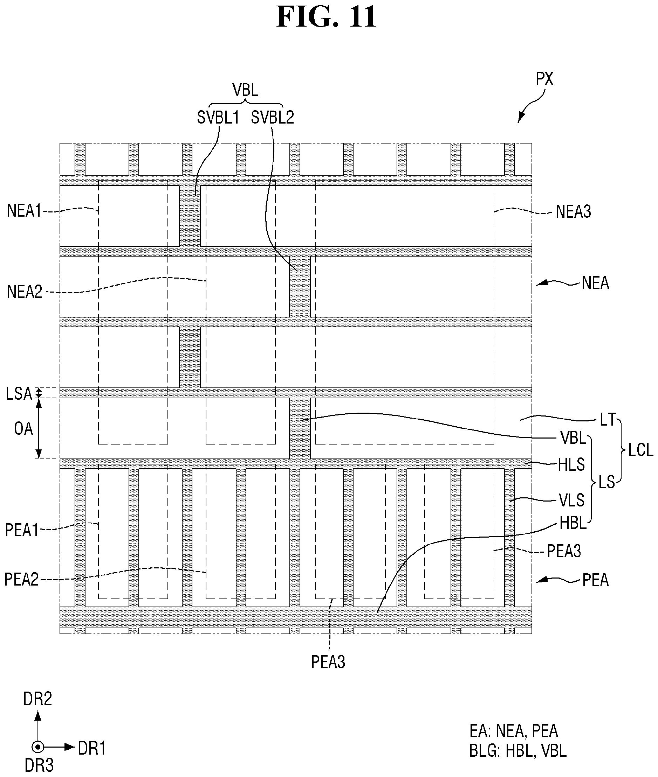

FIG. 11 is a plan view illustrating a pixel and a light control layer of a display device, according to still another embodiment.

In an embodiment and referring to FIG. 11, a display device 10 is different from the display device 10 according to another embodiment described with reference to FIG. 10 in that the shape and arrangement of the bridge BLG are different.

In an embodiment and more specifically, in the display device 10 the bridge BLG may include a sub-bridge. For example, the vertical bridge VBL may include a first sub-vertical bridge SVBL1 and a second sub-vertical bridge SVBL2, and the horizontal bridge HBL may include a first sub-horizontal bridge and a second sub-horizontal bridge.

In an embodiment, although the first sub-horizontal bridge and the second sub-horizontal bridge are not illustrated in the drawing, the first sub-horizontal bridge and the second sub-horizontal bridge may be implemented according to the same technical idea as the first sub-vertical bridge SVBL1 and the second sub-vertical bridge SVBL2. Therefore, the first sub-vertical bridge SVBL1 and the second sub-vertical bridge SVBL2 will be mainly described.

In an embodiment, the first sub-vertical bridge SVBL1 and the second sub-vertical bridge SVBL2 may be disposed between two horizontal light blocking films HLS, respectively. The first sub-vertical bridge SVBL1 and the second sub-vertical bridge SVBL2 may each connect two different horizontal light blocking films HLS.

In an embodiment, the first sub-vertical bridge SVBL1 may be disposed between a (2n-1)-th light blocking film and a (2n)-th light blocking film, and the second sub-vertical bridge SVBL2 may be disposed between the (2n)-th light blocking film and a (2n+1)-th light blocking film. The first sub-vertical bridge SVBL1 may connect between the (2n-1)-th light blocking film and the (2n)-th light blocking film, and the second sub-vertical bridge SVBL2 may connect between the (2n)-th light blocking film and the (2n+1)-th light blocking film.

In another embodiment, the first sub-vertical bridge SVBL1 may be disposed between an odd-numbered horizontal light blocking films HLS and an even-numbered horizontal light blocking films HLS, and the second sub-vertical bridge SVBL2 may be disposed between an even-numbered horizontal light blocking films HLS and an odd-numbered horizontal light blocking films HLS. The first sub-vertical bridge SVBL1 may connect between an odd-numbered horizontal light blocking films HLS and an even-numbered horizontal light blocking films HLS, and the second sub-vertical bridge SVBL2 may connect between an even-numbered horizontal light blocking films HLS and an odd-numbered horizontal light blocking films HLS.

In an embodiment, the first sub-vertical bridge SVBL1 and the second sub-vertical bridge SVBL2 may not overlap each other. For example, the first sub-vertical bridge SVBL1 may be disposed between the first light emitting area NEA1 and the second light emitting area NEA2 of the normal mode area NEA. The second sub-vertical bridge SVBL2 may be disposed between the second light emitting area NEA2 and the third light emitting area NEA3 of the normal mode area NEA. Therefore, the first sub-vertical bridge SVBL1 and the second sub-vertical bridge SVBL2 may not overlap each other in the first to third directions DR1, DR2, and DR3, respectively.

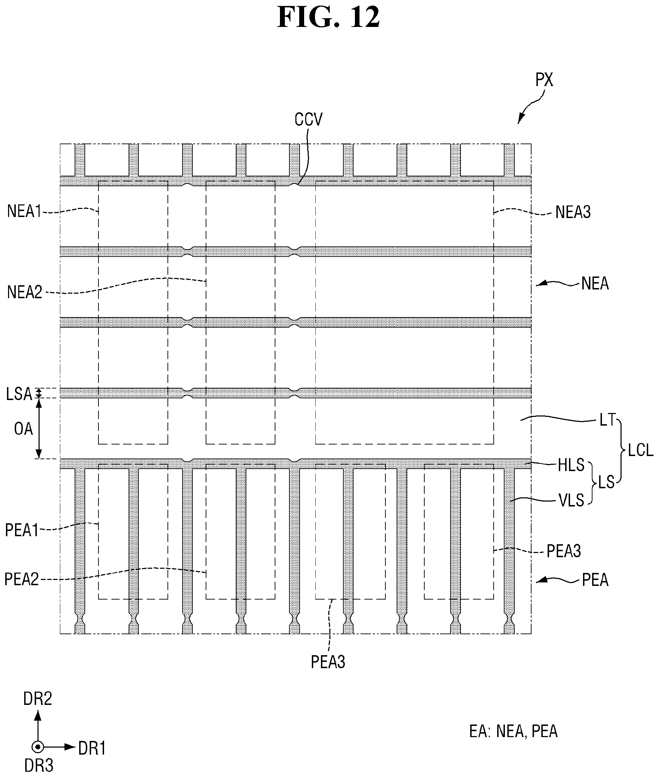

FIGS. 12 to 15 are plan views illustrating pixels and light control layers of a display device, according to still another embodiment.

In an embodiment and referring to FIGS. 12 to 15, a display device 10 is different from the display device 10 according to the embodiments described above with reference to FIGS. 7, 10, 11, and the like in that the plurality of light blocking films LS includes a removal mark.

In an embodiment and more specifically, the plurality of light blocking films LS may include a removal mark. The removal mark may be a mark left on the plurality of light blocking films LS when the bridge BLG in the embodiments of FIGS. 10 and 11 is removed.

In an embodiment, the plurality of light blocking films LS may include a concave portion CCV as a removal mark, as in the embodiment of FIG. 12. The concave portion CCV may be formed by over etching during a process of removing the bridge BLG in the methods S1 and S2 for manufacturing the display device (see FIGS. 18 and 26), which will be described later.

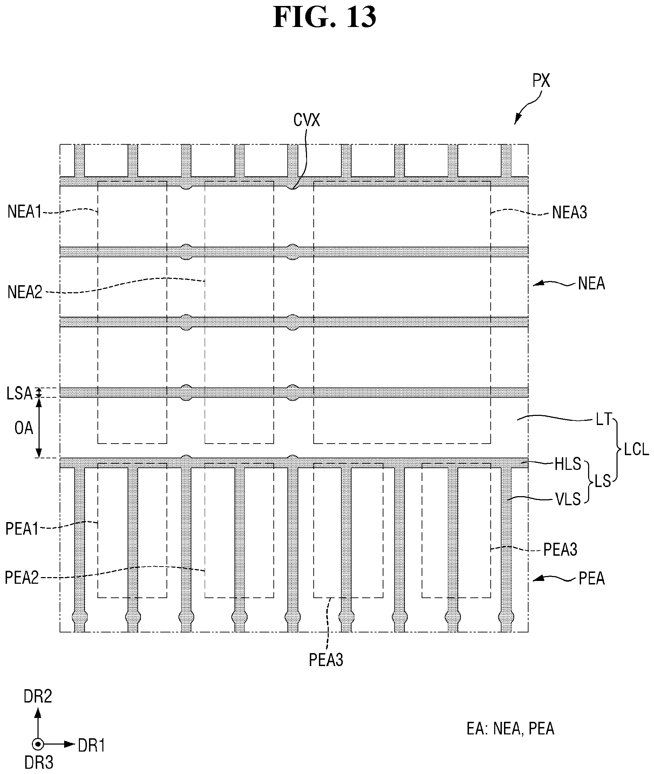

In another embodiment, the plurality of light blocking films LS may include a convex portion CVX as a removal mark, as in the embodiment of FIG. 13. The convex portion CVX is formed by a portion of the bridge BLG being unetched during a process of removing the bridge BLG in the methods S1 and S2 for manufacturing the display device (see FIGS. 18 and 26), which will be described later.

In an embodiment and as illustrated in FIG. 12, the plurality of light blocking films LS may each include the concave portion CCV on at least one of both surfaces thereof. For example, the concave portions CCV of the plurality of light blocking films LS disposed in the normal mode area NEA may face the concave portions CCV of the plurality of light blocking films LS disposed adjacent to each other in the second direction DR2. The concave portions CCV of the plurality of light blocking films LS disposed in the privacy mode area PEA may face the concave portions CCV of the plurality of light blocking films LS disposed adjacent to each other in the first direction DR1.

In an embodiment and as illustrated in FIG. 13, the plurality of light blocking films LS may each include the convex portion CVX on at least one of both surfaces thereof. For example, the convex portions CVX of the plurality of light blocking films LS disposed in the normal mode area NEA may face the convex portions CVX of the plurality of light blocking films LS adjacent to each other in the second direction DR2. The convex portions CVX of the plurality of light blocking films LS disposed in the privacy mode area PEA may face the convex portions CVX of the plurality of light blocking films LS disposed adjacent to each other in the first direction DR1.

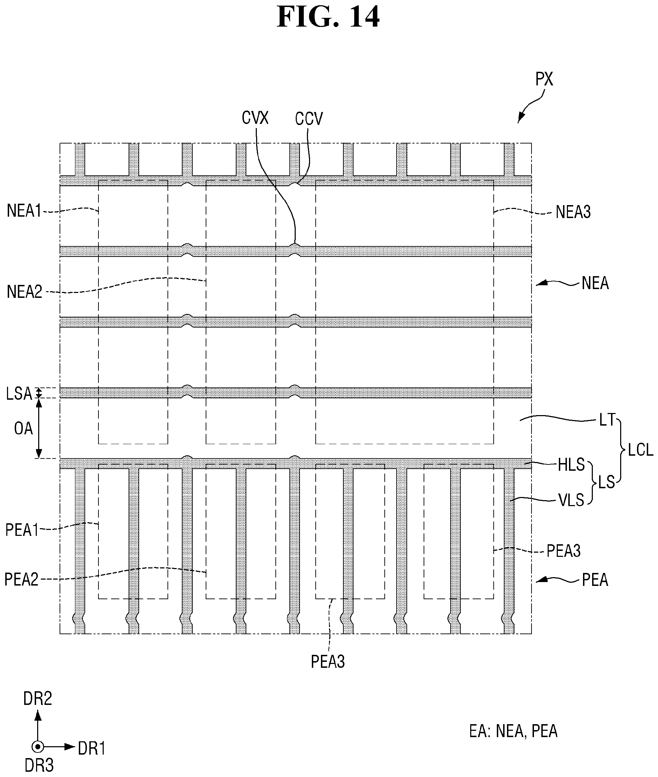

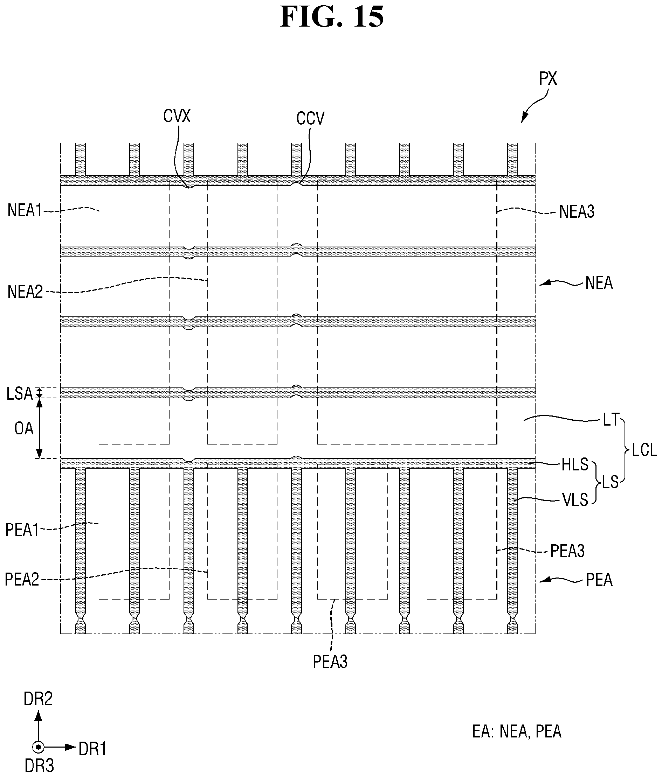

In an embodiment and as illustrated in FIGS. 14 and 15, the plurality of light blocking films LS may include both a concave portion CCV and a convex portion CVX.

In an embodiment and as illustrated in FIG. 14, the plurality of light blocking films LS may each include the convex portion CVX on at least one of both surfaces thereof. For example, the plurality of light blocking films LS disposed in the normal mode area NEA may include a convex portion CVX on one surface positioned on one side in the second direction DR2, and may include a concave portion CCV on the other surface positioned on the other side in the second direction DR2. The plurality of light blocking films LS disposed in the privacy mode area PEA may include a concave portion CCV on one surface positioned on one side in the first direction DR1, and may include a convex portion CVX on the other surface positioned on the other side in the first direction DR1.

However, the invention is not limited thereto, and, in an embodiment, the plurality of light blocking films LS disposed in the normal mode area NEA may also include a concave portion CCV on one surface positioned on one side in the second direction DR2, and may also include a convex portion CVX on the other surface positioned on the other side in the second direction DR2. The plurality of light blocking films LS disposed in the privacy mode area PEA may also include a convex portion CVX on one surface positioned on one side in the first direction DR1, and may include a concave portion CCV on the other surface positioned on the other side in the first direction DR1.

In another embodiment, as illustrated in FIG. 15, both the concave portion CCV and the convex portion CVX may be included on the same surface of one plurality of light blocking films LS.

In an embodiment, the plurality of light blocking films LS disposed in the normal mode area NEA may include both a concave portion CCV and a convex portion CVX on one surface positioned on one side in the second direction DR2 and the other surface positioned on the other side, respectively. As an example, on one surface of the plurality of light blocking films LS positioned on one side in the second direction DR2, the concave portion CCV may be disposed between the first light emitting area NEA1 and the second light emitting area NEA2 of the normal mode area NEA, and the convex portion CVX may be disposed between the second light emitting area NEA2 and the third light emitting area NEA3 thereof. In addition, on the other surface of the plurality of light blocking films LS positioned on the other side in the second direction DR2, the convex portion CVX may be disposed between the first light emitting area NEA1 and the second light emitting area NEA2 of the normal mode area NEA, and the concave portion CCV may be disposed between the second light emitting area NEA2 and the third light emitting area NEA3 thereof.

However, the invention is not limited thereto, and, in an embodiment, on one surface of the plurality of light blocking films LS positioned on one side in the second direction DR2, the convex portion CVX may also be disposed between the first light emitting area NEA1 and the second light emitting area NEA2 of the normal mode area NEA, and the concave portion CCV may also be disposed between the second light emitting area NEA2 and the third light emitting area NEA3 thereof. In addition, on the other surface of the plurality of light blocking films LS positioned on the other side in the second direction DR2, the concave portion CCV may also be disposed between the first light emitting area NEA1 and the second light emitting area NEA2 of the normal mode area NEA, and the convex portion CVX may also be disposed between the second light emitting area NEA2 and the third light emitting area NEA3 thereof.

In an embodiment, although not illustrated in the drawing, both the concave portion CCV and the convex portion CVX may also be disposed on the same surface of the plurality of light blocking films LS disposed in the privacy mode area PEA.

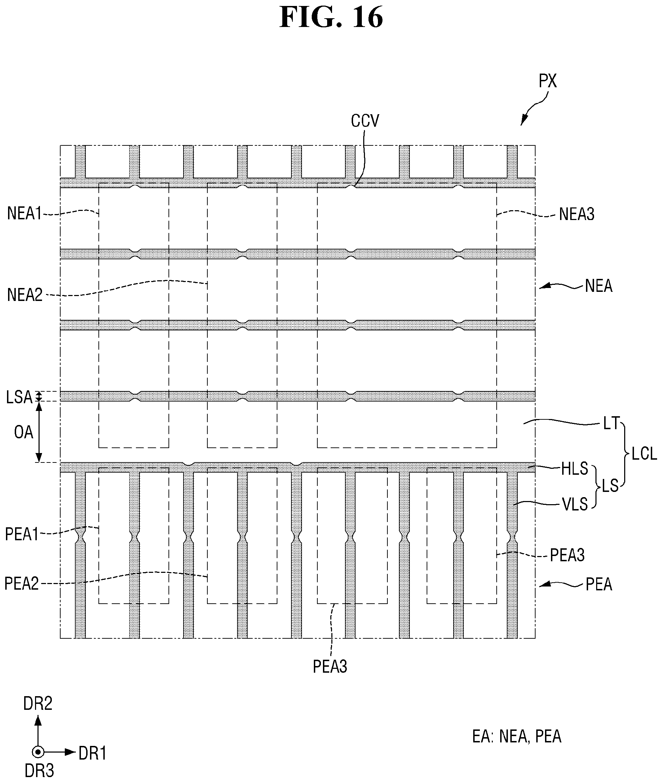

FIG. 16 is a plan view illustrating a pixel and a light control layer of a display device, according to still another embodiment.

In an embodiment and referring to FIG. 16, a display device 10 is different from the display device 10 according to the embodiments described above with reference to FIGS. 12 to 15 in that the removal mark overlaps the light emitting area EA.

In an embodiment and more specifically, in the display device 10, at least one of the removal marks of the plurality of light blocking films LS may overlap the light emitting area EA.

In an embodiment, in the case in which the bridge BLG is not removed as in the embodiment of FIGS. 10 and 11, when the bridge BLG overlaps the light emitting area EA, the luminance of the display device 10 may decrease. For example, when the bridge BLG overlaps the light emitting area EA, luminance in the first direction DR1 may decrease in the normal mode area NEA, and luminance in the second direction DR2 may decrease in the privacy mode area PEA.

In an embodiment, as in the display device 10 when the bridge BLG is removed and only the removal mark remains, there is no problem even if the bridge BLG overlaps the light emitting area EA before the bridge BLG is removed. Therefore, when the bridge BLG overlaps the light emitting area EA before the bridge BLG is removed, the removal mark may overlap the light emitting area EA after removal of the bridge BLG.

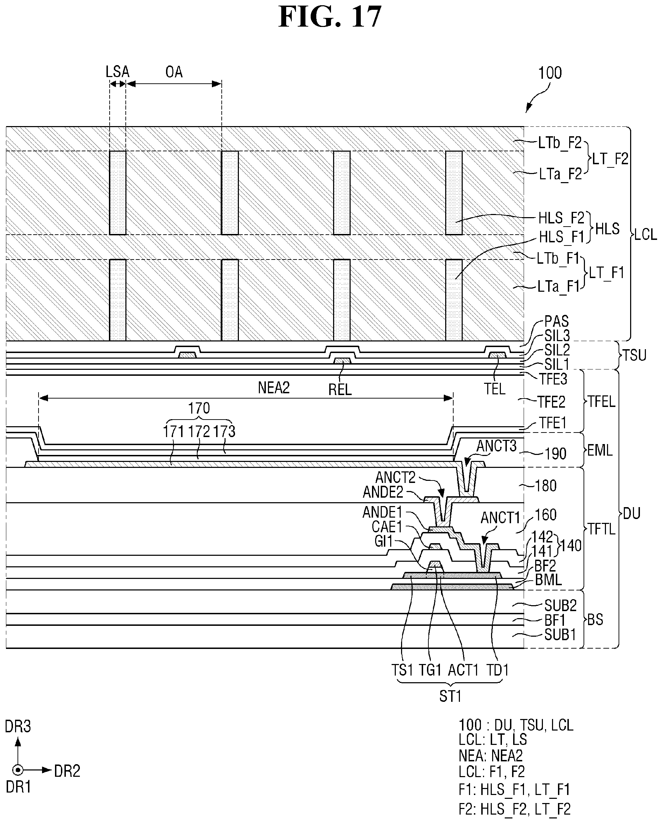

FIG. 17 is a cross-sectional view illustrating a display device, according to still another embodiment.

In an embodiment and referring to FIG. 17, a display device 10 is different from the display device 10 according to the embodiment described with reference to FIG. 8 and the like in that the light control layer LCL includes two or more stages of a plurality of light blocking films LS and a light transmitting film LT.

In an embodiment and more specifically, in the display device 10 the light control layer LCL may include a first stage F1 and a second stage F2. The light control layer LCL may include a plurality of light blocking films LS and a light transmitting film LT.

In an embodiment, the plurality of horizontal light blocking films HLS (see FIG. 8) of the normal mode area NEA is described as an example, but the same may be applied to the plurality of vertical light blocking films VLS (see FIG. 9) of the privacy mode area PEA.

In an embodiment, the first stage F1 may be disposed on the display layer DU or the touch sensor layer TSU. The first stage F1 may include a first stage horizontal light blocking film HLS_F1 and a first stage light transmitting film LT_F1. The first stage light transmitting film LT_F1 may include a first portion LTa_F1 and a second portion LTb_F1.

In an embodiment, the first stage horizontal light blocking film HLS_F1 may be disposed on the display layer DU or the touch sensor layer TSU. The first stage horizontal light blocking film HLS_F1 may be disposed in the non-transmissive area LSA. The first stage horizontal light blocking film HLS_F1 may include the same material as the plurality of light blocking films LS described with reference to FIG. 8 and the like.

In an embodiment, the first stage light transmitting film LT_F1 may be disposed on the display layer DU or the touch sensor layer TSU. The first stage light transmitting film LT_F1 may be disposed in the transmissive area OA and the non-transmissive area LSA. The first stage light transmitting film LT_F1 may include the same material as the light transmitting film LT described with reference to FIG. 8 and the like.

In an embodiment, the first stage light transmitting film LT_F1 may include a first portion LTa_F1 and a second portion LTb_F1.

In an embodiment, the first portion LTa_F1 of the first stage light transmitting film LT_F1 may be disposed between the first stage horizontal light blocking films HLS_F1. The first portion LTa_F1 of the first stage light transmitting film LT_F1 may be disposed in the transmissive area OA. For example, the first portion LTa_F1 of the first stage light transmitting film LT_F1 may be positioned at the same height as the first stage horizontal light blocking films HLS_F1 in the third direction DR3. The height of the first portion LTa_F1 of the first stage light transmitting film LT_F1 may be the same as the height of the first stage horizontal light blocking films HLS_F1.

In an embodiment, the second portion LTb_F1 of the first stage light transmitting film LT_F1 may be disposed on the first stage horizontal light blocking films HLS_F1 and the first portion LTa_F1 of the first stage light transmitting film LT_F1. The second portion LTb_F1 of the first stage light transmitting film LT_F1 may be disposed in the transmissive area OA and the non-transmissive area LSA. The second portion LTb_F1 of the first stage light transmitting film LT_F1 may be entirely disposed on the first stage horizontal light blocking films HLS_F1 and the first portion LTa_F1 of the first stage light transmitting film LT_F1.

In an embodiment, when a material for forming the plurality of light blocking films LS of the first stage F1 is first applied to perform a patterning and a material for forming the light transmitting film LT of the first stage F1 is applied, the second portion LTb_F1 of the first stage light transmitting film LT_F1 may be formed when the material for forming the light transmitting film LT of the first stage F1 is excessively applied onto the plurality of light blocking films LS of the first stage F1. In another embodiment, the second portion LTb_F1 of the first stage light transmitting film LT_F1 may also be omitted.

In an embodiment, the second stage F2 may be disposed on the first stage F1. The second stage F2 may include a second stage horizontal light blocking film HLS_F2 and a second stage light transmitting film LT_F2. The second stage light transmitting film LT_F2 may include a first portion LTa_F2 and a second portion LTb_F2.

In an embodiment, the second stage horizontal light blocking film HLS_F2 may be disposed on the first stage horizontal light blocking film HLS _F1. The second stage horizontal light blocking film HLS_F2 may be disposed in the non-transmissive area LSA. The second stage horizontal light blocking film HLS_F2 may overlap the first stage horizontal light blocking film HLS_F1 in the third direction DR3. The second stage horizontal light blocking film HLS_F2 may include the same material as the first stage horizontal light blocking film HLS _F1.

In an embodiment, the second stage light transmitting film LT _F2 may be disposed on the first stage light transmitting film LT_F1. The second stage light transmitting film LT_F2 may be disposed in the transmissive area OA and the non-transmissive area LSA. The second stage light transmitting film LT _F2 may include the same material as the first stage light transmitting film LT_F1.

In an embodiment, the second stage light transmitting film LT _F2 may include a first portion LTa_F2 and a second portion LTb_F2.

In an embodiment, the first portion LTa_F2 of the second stage light transmitting film LT_F2 may be disposed between the second stage horizontal light blocking films HLS_F2. The first portion LTa_F2 of the second stage light transmitting film LT_F2 may be disposed in the transmissive area OA. For example, the first portion LTa_F2 of the second stage light transmitting film LT_F2 may be positioned at the same height as the second stage horizontal light blocking films HLS_F2 in the third direction DR3. The height of the first portion LTa_F2 of the second stage light transmitting film LT _F2 may be the same as the height of the second stage horizontal light blocking film HLS_F2.

In an embodiment, the second portion LTb _F2 of the second stage light transmitting film LT_F2 may be disposed on the second stage horizontal light blocking film HLS_F2 and the first portion LTa_F2 of the second stage light transmitting film LT_F2. The second portion LTb_F2 of the second stage light transmitting film LT_F2 may be disposed in the transmissive area OA and the non-transmissive area LSA. The second portion LTb_F2 of the second stage light transmitting film LT_F2 may be entirely disposed on the second stage horizontal light blocking film HLS_F2 and the first portion LTa_F2 of the second stage light transmitting film LT_F2.

In an embodiment, when a material for forming the plurality of light blocking films LS of the second stage F2 is first applied to perform a patterning and a material for forming the light transmitting film LT of the second stage F2 is applied, the second portion LTb_F2 of the second stage light transmitting film LT_F2 may be formed when the material for forming the light transmitting film LT of the second stage F2 is excessively applied onto the plurality of light blocking films LS of the second stage F2. In another embodiment, the second portion LTb_F2 of the second stage light transmitting film LT_F2 may also be omitted.

In the display device 10, according to an embodiment, the light control layer LCL may include a plurality of stages, thereby reducing the height of the plurality of light blocking films LS included in one stage. Accordingly, when patterning the plurality of light blocking films LS, an etch depth is reduced compared to an etch width, so that a side profile of the plurality of light blocking films LS may be formed to be close to about 90 degrees. In addition, since the height of the plurality of light blocking films LS of the light control layer LCL may be formed to be high, viewing angle control characteristics may be improved.

An embodiment is illustrated in the drawing that the light control layer LCL includes two stages, but the present disclosure is not limited thereto. The light control layer LCL may include three or more stages.

Hereinafter, various embodiments of a method for manufacturing a display device will be described. In an embodiment, a method of manufacturing the display device described above with reference to FIGS. 7 to 16 will be described with reference to FIGS. 18 to 25. In an embodiment, a method of manufacturing the display device described above with reference to FIG. 17 will be described with reference to FIGS. 26 to 37.

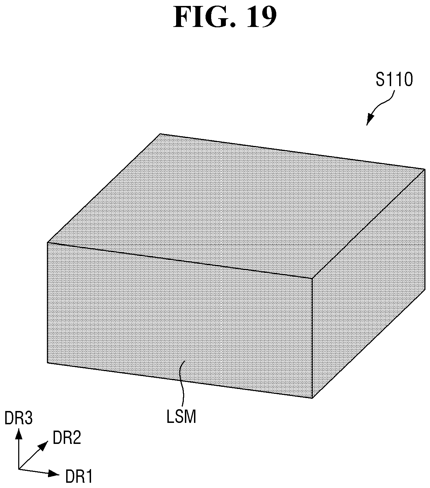

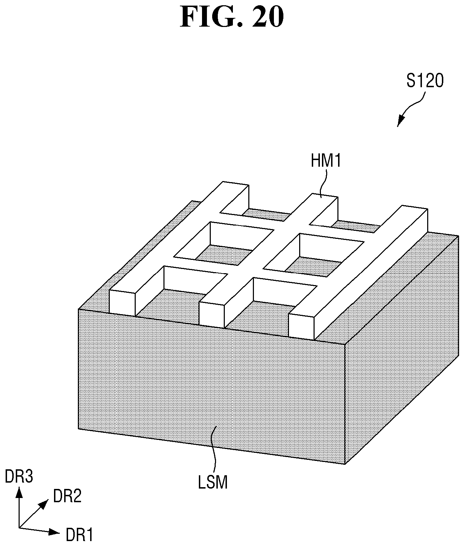

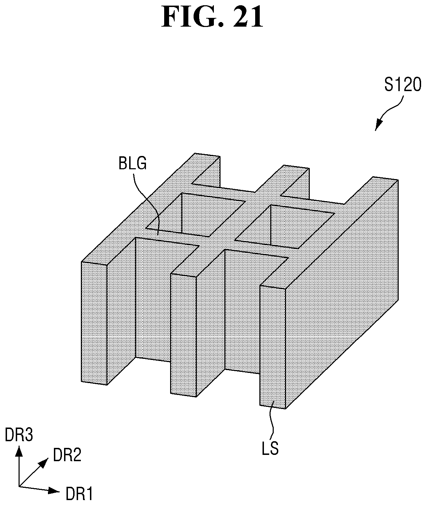

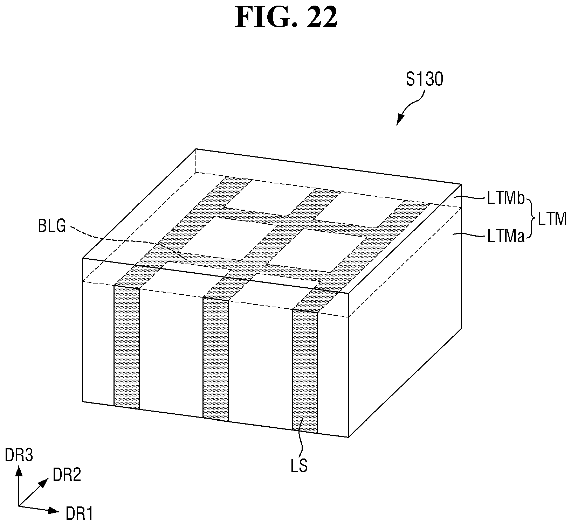

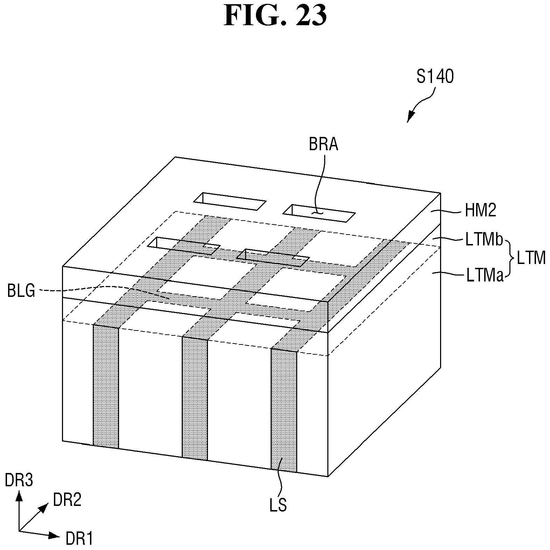

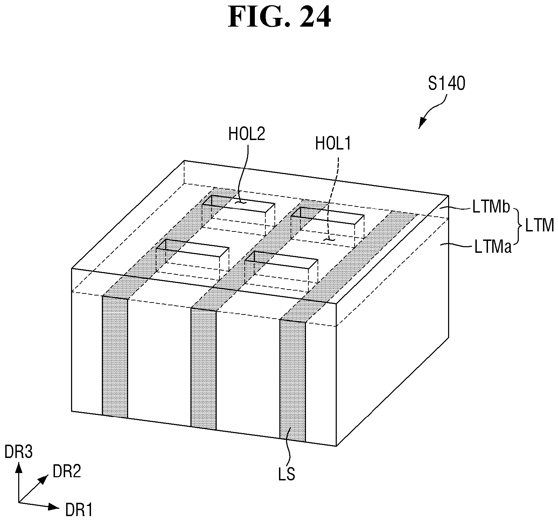

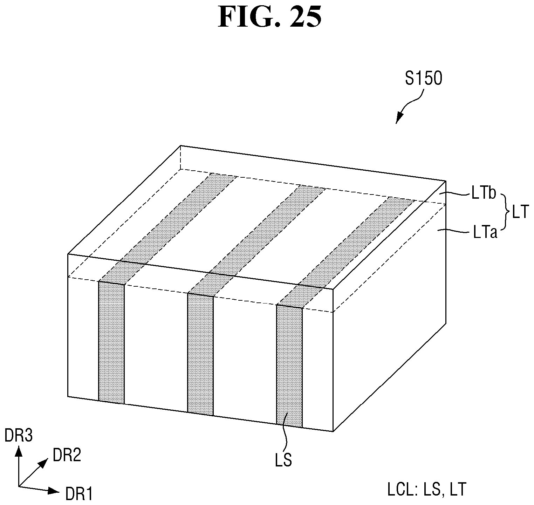

FIG. 18 is a flowchart illustrating a method for manufacturing a display device, according to an embodiment. FIG. 19 is a perspective view illustrating step S110 of FIG. 18, according to an embodiment. FIGS. 20 and 21 are perspective views illustrating step S120 of FIG. 18, according to an embodiment. FIG. 22 is a perspective view illustrating step S130 of FIG. 18, according to an embodiment. FIGS. 23 and 24 are perspective views illustrating step S140 of FIG. 18, according to an embodiment. FIG. 25 is a perspective view illustrating step S150 of FIG. 18, according to an embodiment.

In an embodiment and referring to FIGS. 18 to 25, a method S1 for manufacturing a display device may include forming a light blocking material layer (S110), forming a plurality of light blocking films and a bridge by patterning the light blocking material layer (S120), forming a light transmitting material layer (S130), removing a portion of the light transmitting material layer and the bridge (S140), and forming a light transmitting film (S150).

In an embodiment and as illustrated in FIG. 19, in the step (S110) of forming the light blocking material layer, a light blocking material layer LSM may be formed on the display layer or the touch sensor layer. The light blocking material layer LSM may include an organic material including an organic black pigment such as carbon black, as a photosensitive resin capable of absorbing or blocking light, but is not limited thereto.

In an embodiment and as illustrated in FIGS. 20 and 21, in the step (S120) of forming the plurality of light blocking films and the bridge by patterning the light blocking material layer, a first hard mask HM1 may be disposed on the light blocking material layer LSM.

In an embodiment, the first hard mask HM1 may be formed through a deposition process and a patterning process. For example, a material included in the first hard mask HM1 may be deposited on the light blocking material layer LSM. The material included in the first hard mask HM1 may include at least one of aluminum, chromium, copper, nickel, and oxides thereof, but is not limited thereto.

In an embodiment, the material included in the first hard mask HM1 may be deposited through a sputtering process, which is one of the physical vapor deposition (PVD) methods. However, the material included in the first hard mask HM1 is not limited thereto, and may also be deposited through a chemical vapor deposition (CVD) method or an atomic layer deposition (ALD) method.

In an embodiment, the first hard mask HM1 may be formed by patterning the material layer of the first hard mask HM1. For example, the first hard mask HM1 may be patterned through a photolithography process.

In an embodiment, the plurality of light blocking films LS and the bridge BLG may be formed by patterning the light blocking material layer LSM using the first hard mask HM1. For example, the light blocking material layer LSM in a portion that does not overlap the first hard mask HM1 may be etched through dry etching, but is not limited thereto.

In an embodiment, by etching the light blocking material layer LSM, the plurality of light blocking films LS extending in the first direction DR1 and the bridge BLG extending in the second direction DR2 may be formed. A space surrounded by the plurality of light blocking films LS and the bridge BLG may be an empty space.

In an embodiment and as illustrated in FIG. 22, in the step (S130) of forming the light transmitting material layer, a light transmitting material layer LTM may be formed in the empty space, around the plurality of light blocking films LS, and on the plurality of light blocking films LS.

In an embodiment for example, a material included in the light transmitting material layer LTM may be applied to the empty space, around the plurality of light blocking films LS, and on the plurality of light blocking films LS. The light transmitting material layer LTM may include a first portion LTMa positioned in the empty space and around the plurality of light blocking films LS, and a second portion LTMb positioned on the plurality of light blocking films LS.

In an embodiment, the material included in the light transmitting material layer LTM may include an organic film made of an acryl resin, an epoxy resin, a phenolic resin, a polyamide resin, a polyimide resin, or the like. In another embodiment, the material included in the light transmitting material layer LTM may include silicon oxynitride or silicon oxide.

In some embodiments, when the material included in the light transmitting material layer LTM is applied to an extent that does not overflow the first portion LTMa of the light transmitting material layer LTM, the second portion LTMb may be omitted. However, since it is not easy to apply the material included in the light transmitting material layer LTM to an extent that does not overflow the first portion LTMa of the light transmitting material layer LTM, in most cases, the second portion LTMb of the light transmitting material layer LTM may be formed.

In an embodiment, when the material for forming the light transmitting film LT is first applied to perform a patterning, and then the material for forming the plurality of light blocking films LS is applied, an additional polishing process such as a chemical mechanical polishing (CMP) process needs to be performed to remove the plurality of light blocking films LS excessively applied onto an upper surface of the light transmitting film LT. On the other hand, according to the method S1 for manufacturing the display device 10 according to an embodiment, since the material for forming the plurality of light blocking films LS is first applied to perform a patterning, and then the material for forming the light transmitting film LT is applied, process efficiency may be improved because there is no need to remove the light transmitting film LT excessively applied onto the plurality of light blocking films LS, that is, the second portion LTMb.

In an embodiment, when the manufacturing process according to the method S1 for manufacturing the display device 10 is performed only from steps S110 to S130, the display device 10 according to the embodiments described with reference to FIGS. 10 and 11 may be manufactured.

In an embodiment, when the manufacturing process according to the method S1 for manufacturing the display device is performed only from steps S110 to S150, the display device 10 according to the embodiments described with reference to FIGS. 9 and 12 to 16 may be manufactured.

In an embodiment and as illustrated in FIGS. 23 and 24, in the step (S140) of removing a portion of the light transmitting material layer and the bridge, a second hard mask HM2 may be disposed on the plurality of light blocking films LS, the bridge BLG, and the light transmitting material layer LTM.

In an embodiment, the second hard mask HM2 may be formed in the same manner as the first hard mask HM1.

In an embodiment, a portion of the light transmitting material layer LTM and the bridge BLG may be removed using the second hard mask HM2. For example, a portion of the light transmitting material layer LTM and the bridge BLG that do not overlap the second hard mask HM2 may be etched through dry etching, but are not limited thereto.

In an embodiment, the second hard mask HM2 may include a bridge removal area BRA. The bridge removal area BRA may overlap the bridge BLG in the third direction DR3. A slit of the second hard mask HM2 may be positioned in the bridge removal area BRA. That is, an opening of the second hard mask HM2 may be disposed in the bridge removal area BRA.

In an embodiment, in the bridge removal area BRA, the bridge BLG and a portion of the light transmitting material layer LTM that overlaps the bridge BLG may be removed. Accordingly, as the bridge BLG is removed, a first hole HOL1 may be formed, and as a portion of the light transmitting material layer LTM overlapping the bridge BLG is removed, a second hole HOL2 may be formed. The first hole HOL1 and the second hole HOL2 may be one connected through hole that penetrates through the entire light transmitting material layer LTM.

In an embodiment, the first hole HOL1 may be positioned at the same height as the first portion LTMa of the light transmitting material layer LTM. The first hole HOL1 may be surrounded by the first portion LTMa of the light transmitting material layer LTM. The first hole HOL1 may be a hole penetrating through the first portion LTMa of the light transmitting material layer LTM in the third direction DR3.

In an embodiment, the second hole HOL2 may be positioned at the same height as the second portion LTMb of the light transmitting material layer LTM. The second hole HOL2 may be surrounded by the second portion LTMb of the light transmitting material layer LTM. The second hole HOL2 may be a hole penetrating through the second portion LTMb of the light transmitting material layer LTM in the third direction DR3.

In an embodiment and as illustrated in FIG. 25, in the step (S150) of forming the light transmitting film, a material included in the light transmitting material layer LTM may be additionally applied to fill the first hole HOL1 and the second hole HOL2. Accordingly, the first portion LTa and the second portion LTb of the light transmitting film LT may be formed.

In an embodiment, although not illustrated in the drawing, the removal marks such as the concave portions CCV and the convex portions CVX described with reference to FIGS. 12 to 16 may be included in the plurality of light blocking films LS of the light control layer LCL.

In an embodiment and according to the method S1 for manufacturing the display device, by first applying the material for forming the plurality of light blocking films LS to perform the patterning, and then applying the material for forming the light transmitting film LT, a side profile of the plurality of light blocking films LS may have excellent characteristics. For example, by first applying the material for forming the plurality of light blocking films LS to perform the patterning, and then applying the material for forming the light transmitting film LT, the side profile of the plurality of light blocking films LS may be formed to be close to about 90 degrees, or may be formed in a normal-tapered shape where an upper portion is narrower than a lower portion. As the side profile of the plurality of light blocking films LS is formed to be close to about 90 degrees, or is formed in the normal-tapered shape where the upper portion is narrower than the lower portion, viewing angle control and luminance characteristics may be improved.

In an embodiment and according to the method S1 for manufacturing the display device 10, the plurality of light blocking films LS may include the bridge BLG, thereby preventing the plurality of light blocking films LS from collapsing during the patterning process of the plurality of light blocking films LS. For example, as described above with reference to FIGS. 8 and 9, the width of the plurality of light blocking films LS may be very small compared to the height of the plurality of light blocking films LS. Therefore, when the material for forming the plurality of light blocking films LS is first applied to perform the patterning and then the material for forming the light transmitting film LT is applied, the plurality of light blocking films LS may collapse in a direction different from the direction of extension thereof due to the thin width compared to the height. In an embodiment and according to the method S1 for manufacturing the display device 10, the plurality of light blocking films LS may include the bridge BLG, thereby preventing the plurality of light blocking films LS from collapsing.

In an embodiment and according to the method S1 for manufacturing the display device 10, process efficiency may be improved by removing the bridge BLG when the bridge BLG overlaps the light emitting area EA, and not removing the bridge BLG when the bridge BLG does not overlap the light emitting area EA.

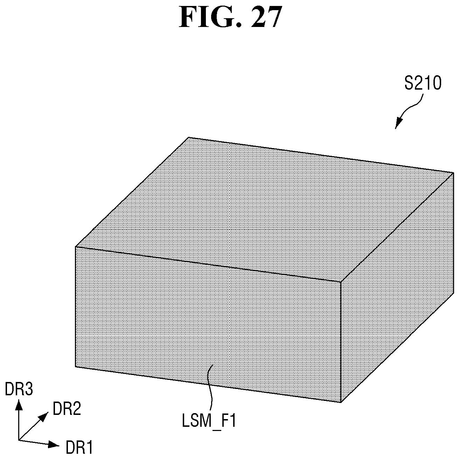

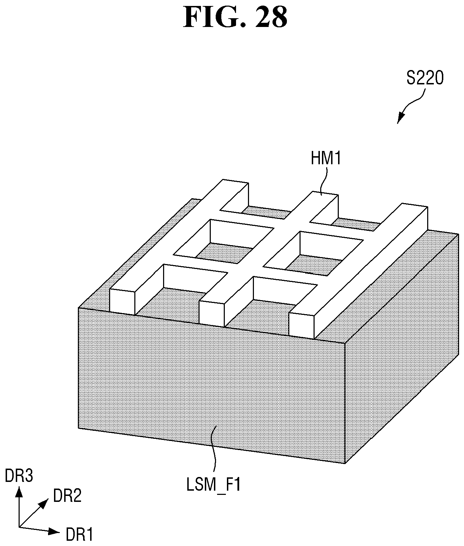

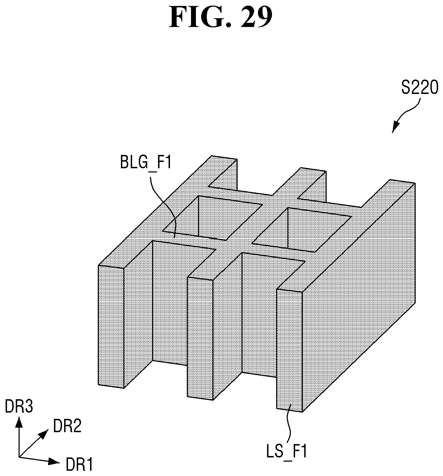

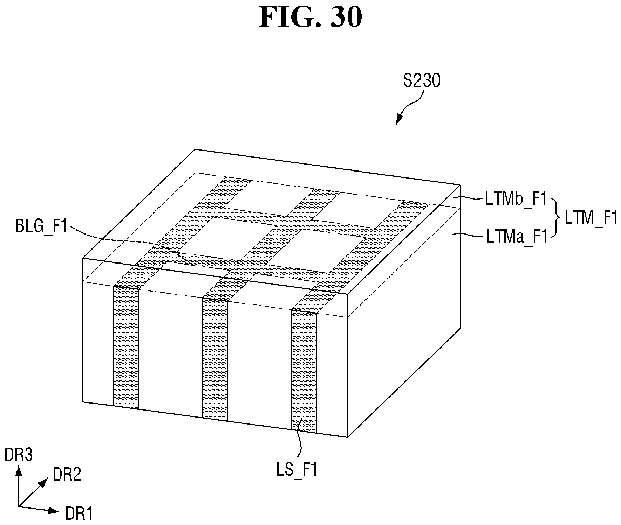

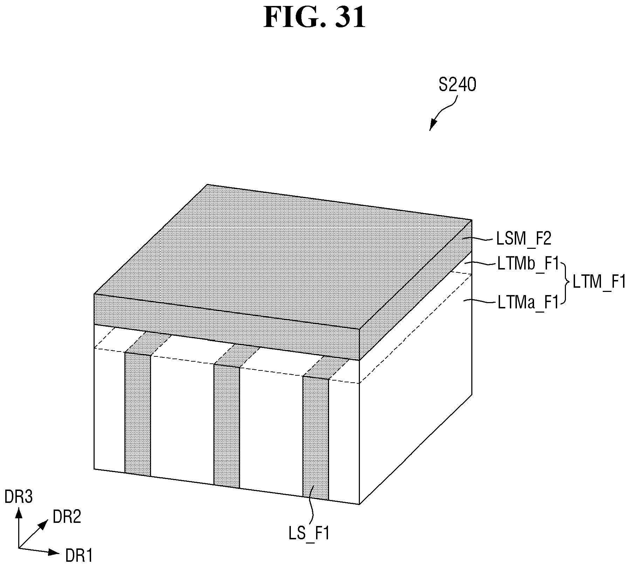

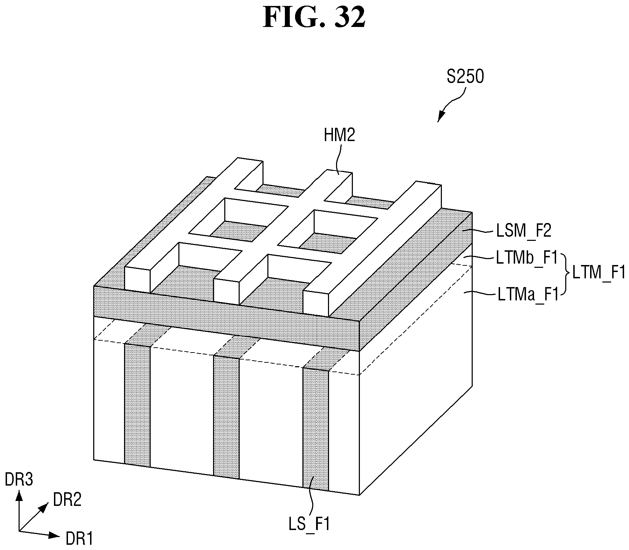

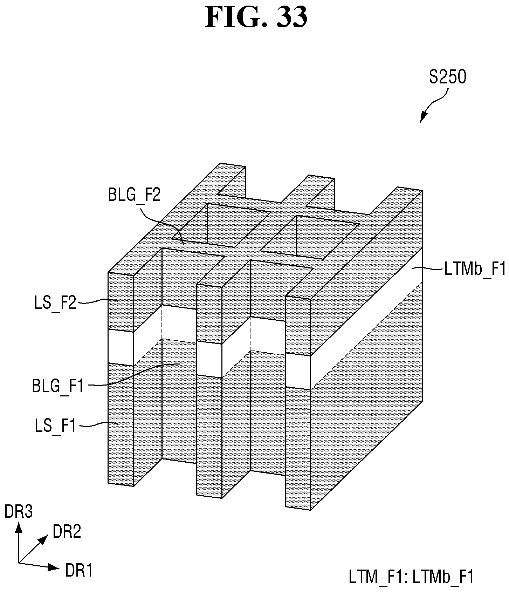

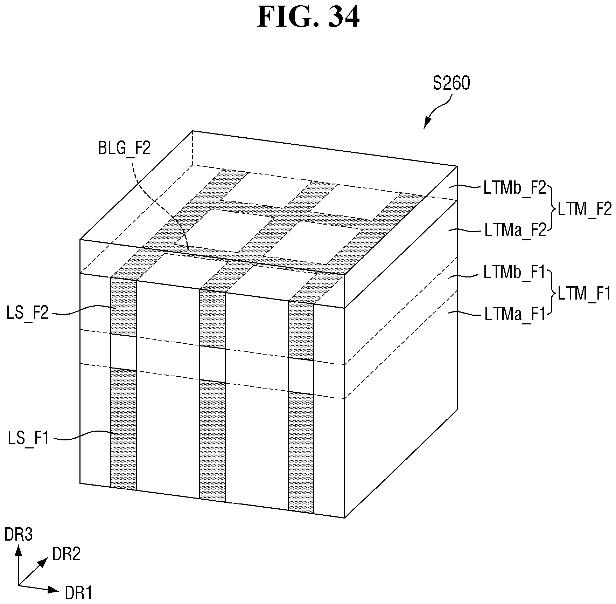

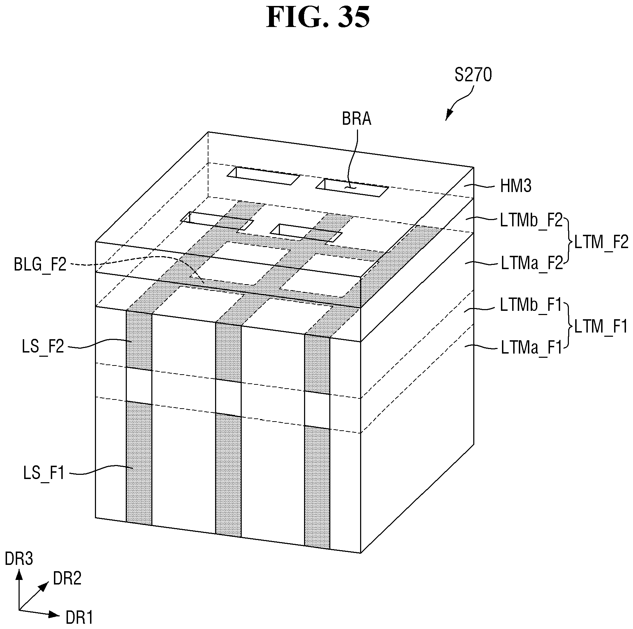

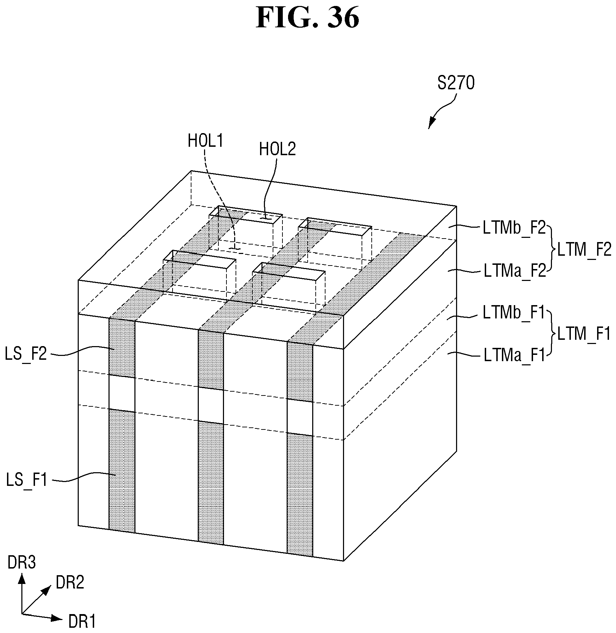

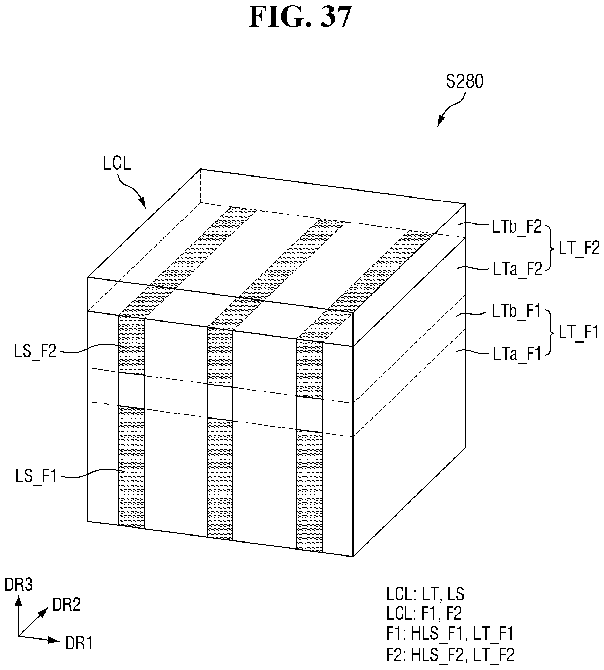

FIG. 26 is a flowchart illustrating a method for manufacturing a display device 10, according to another embodiment. FIG. 27 is a perspective view illustrating step S210 of FIG. 26, according to an embodiment. FIGS. 28 and 29 are perspective views illustrating step S220 of FIG. 26, according to an embodiment. FIG. 30 is a perspective view illustrating step S230 of FIG. 26, according to an embodiment. FIG. 31 is a perspective view illustrating step S240 of FIG. 26, according to an embodiment. FIGS. 32 and 33 are perspective views illustrating step S250 of FIG. 26, according to an embodiment. FIG. 34 is a perspective view illustrating step S260 of FIG. 26, according to an embodiment. FIGS. 35 and 36 are perspective views illustrating step S270 of FIG. 26, according to an embodiment. FIG. 37 is a perspective view illustrating step S280 of FIG. 26, according to an embodiment.

In an embodiment and referring to FIGS. 26 to 37, a method S2 for manufacturing a display device may include forming a first stage light blocking material layer (S210), forming a first stage light blocking film and a first stage bridge by patterning the first stage light blocking material layer (S220), forming a first stage light transmitting material layer (S230), forming a second stage light blocking material layer (S240), forming a second stage light blocking film and a second stage bridge by patterning the second stage light blocking material layer (S250), forming a second stage light transmitting material layer (S260), removing a portion of the first stage light transmitting material layer, a portion of the second stage light transmitting material layer, and the first stage bridge and the second stage bridge (S270), and forming a first stage light transmitting film and a second stage light transmitting film (S280).

In an embodiment and as illustrated in FIG. 27, in the step (S210) of forming the first stage light blocking material layer, a first stage light blocking material layer LSM_F1 may be formed on the display layer or the touch sensor layer. The first stage light blocking material layer LSM_F1 may include at least one of the same materials as the light blocking material layer LSM described above with reference to FIG. 19 and the like.

In an embodiment and as illustrated in FIGS. 28 and 29, in the forming of the first stage light blocking film and the first stage bridge by patterning the first stage light blocking material layer, a first hard mask HM1 may be disposed on the first light blocking material layer LSM _F1.

In an embodiment, the first hard mask HM1 may be formed in the same manner as the first hard mask HM1 described above with reference to FIG. 20 and the like.

In an embodiment, a first stage light blocking film LS_F1 and a first stage bridge BLG_F1 may be formed by patterning the first stage light blocking material layer LSM _F1 using the first hard mask HM1. For example, the first stage light blocking material layer LSM_F1 in a portion that does not overlap the first hard mask HM1 may be etched through dry etching, but is not limited thereto.

In an embodiment, by etching the first stage light blocking material layer LSM_F1, the first stage light blocking film LS_F1 extending in the first direction DR1 and the first stage bridge BLG_F1 extending in the second direction DR2 may be formed. A space surrounded by the first stage light blocking film LS_F1 and the first stage bridge BLG_F1 may be an empty space.

In an embodiment and as illustrated in FIG. 30, in the step (S230) of forming the first stage light transmitting material layer, a first stage light transmitting material layer LTM_F1 may be formed in the empty space, around the first stage light blocking film LS_F1, and on the first stage light blocking film LS_F1.

In an embodiment, for example, a material included in the first light transmitting material layer LTM_F1 may be applied to the empty space, around the first stage light blocking film LS_F1, and on the first stage light blocking film LS _F1. The first stage light transmitting material layer LTM_F1 may include a first portion LTMa_F1 positioned in the empty space and around the first stage light blocking film LS_F1, and a second portion LTMb_F1 disposed on the first stage light blocking film LS_F1.

In an embodiment, the first stage light transmitting material layer LTM _F1 may include at least one of the same materials as the light transmitting material layer LTM described above with reference to FIG. 22 and the like.

In some embodiments, when the material included in the first stage light transmitting material layer LTM_F1 is applied to an extent that does not overflow the first portion LTMa_F1 of the first stage light transmitting material layer LTM_F1, the second portion LTMb_F1 may be omitted. However, since it is not easy to apply the material included in the first stage light transmitting material layer LTM_F1 to an extent that does not overflow the first portion LTMa_F1 of the first stage light transmitting material layer LTM_F1, in other embodiments, the second portion LTMb_F1 of the first stage light transmitting material layer LTM_F1 may be formed.

In an embodiment and when the material for forming the first stage light transmitting film LT_F1 is first applied to perform a patterning, and then the material for forming the first stage light blocking film LS_F1 is applied, an additional polishing process such as a chemical mechanical polishing (CMP) process needs to be performed to remove the first stage light blocking film LS_F1 excessively applied onto an upper surface of the first stage light transmitting film L T _F 1. In an embodiment, according to the method S2 for manufacturing the display device, since the material for forming the first stage light blocking film LS_F1 is first applied to perform the patterning, and then the material for forming the first stage light transmitting film LT_F1 is applied, process efficiency may be improved because there is no need to remove the first stage light transmitting film LT_F1 excessively applied onto the first stage light blocking film LS_F1, that is, the second portion LTMb_F1.

In an embodiment and as illustrated in FIG. 31, in the step (S240) of forming the second stage light blocking material layer, a second stage light blocking material layer LSM_F2 may be formed on the first stage light blocking film LS_F1 and the first stage light transmitting material layer LTM_F1. The second stage light blocking material layer LSM_F2 may include at least one of the same materials as the first stage light blocking material layer LSM _F1.

In an embodiment and as illustrated in FIGS. 32 and 33, in the step (S250) of forming of the second stage light blocking film and the second stage bridge by patterning the second stage light blocking material layer, a second hard mask HM2 may be disposed on the second light blocking material layer LSM_F2.

In an embodiment, the second hard mask HM2 may be formed in the same manner as the first hard mask HM1.

In an embodiment, a second stage light blocking film LS_F2 and a second stage bridge BLG_F2 may be formed by patterning the second stage light blocking material layer LSM_F2 using the second hard mask HM2. For example, the second stage light blocking material layer LSM_F2 in a portion that does not overlap the second hard mask HM2 may be etched through dry etching, but is not limited thereto.

In an embodiment, by etching the second stage light blocking material layer LSM_F2, the second stage light blocking film LS_F2 extending in the first direction DR1 and the second stage bridge BLG_F2 extending in the second direction DR2 may be formed. A space surrounded by the second stage light blocking film LS_F2 and the second stage bridge BLG_F2 may be an empty space.

In an embodiment, the first portion LTMa_F1 of the first stage light transmitting material layer LTM_F1 does not overlap the second hard mask HM2 and may be thus completely removed, and only a portion of the second portion LTMb_F1 of the first light transmitting material layer LTM_F1 that does overlap the second hard mask HM2 may not be removed. Accordingly, the first light transmitting material layer LTM_F1 may have the same shape as the second hard mask HM2 in a plan view.

In an embodiment and as illustrated in FIG. 34, in the step (S260) of forming the second stage light transmitting material layer, a second stage light transmitting material layer LTM_F2 may be formed in the empty space, around the second stage light blocking film LS _F2, and on the second stage light blocking film LS_F2.

In an embodiment, a material included in the second light transmitting material layer LTM_F2 may be applied to the empty space, around the second light blocking film LS _F2, and on the second light blocking film LS_F2. The second stage light transmitting material layer LTM_F2 may include a first portion LTMa_F2 positioned in the empty space and around the second stage light blocking film LS _F2, and a second portion LTMb_F2 disposed on the second stage light blocking film LS_F2.

In an embodiment, portions of the first portion LTMa_F1 and the second portion LTMb_F1 of the first stage light transmitting material layer LTM_F1 removed in the step (S250) may also be formed again.

In an embodiment, the second stage light transmitting material layer LTM_F2 may include at least one of the same materials as the light transmitting material layer LTM described with reference to FIG. 22 and the like.

In some embodiments, when the material included in the second stage light transmitting material layer LTM_F2 is applied to an extent that does not overflow the first portion LTMa_F2 of the second stage light transmitting material layer LTM_F2, the second portion LTMb_F2 may be omitted. However, since it is not easy to apply the material included in the second stage light transmitting material layer LTM_F2 to an extent that does not overflow the first portion LTMa_F2 of the second stage light transmitting material layer LTM_F2, in most cases, the second portion LTMb_F2 of the second stage light transmitting material layer LTM_F2 may be formed.

In an embodiment and when the material for forming the second stage light transmitting film LT_F2 is first applied to perform the patterning, and then the material for forming the second stage light blocking film LS_F2 is applied, an additional polishing process such as a chemical mechanical polishing (CMP) process needs to be performed to remove the second stage light blocking film LS_F2 excessively applied onto an upper surface of the second stage light transmitting film LT_F2. In an embodiment, according to the method S2 for manufacturing the display device, since the material for forming the second stage light blocking film LS_F2 is first applied to perform the patterning, and then the material for forming the second stage light transmitting film LT_F2 is applied, process efficiency may be improved because there is no need to remove the second stage light transmitting film LT_F2 excessively applied onto the second stage light blocking film LS_F2, that is, the second portion LTMb_F2.

In an embodiment and as illustrated in FIGS. 35 and 36, in the step (S270) of removing a portion of the first stage light transmitting material layer, a portion of the second stage light transmitting material layer, and the first stage bridge and the second stage bridge, a third hard mask HM3 may be disposed on the plurality of light blocking films LS, the bridge BLG, and the light transmitting material layer LTM.

In an embodiment, the third hard mask HM3 may be formed in the same manner as the first hard mask HM1.

In an embodiment, a portion of the first stage light transmitting material layer LTM_F1, a portion of the second stage light transmitting material layer LTM_F2, and the first stage bridge BLG_F1 and the second stage bridge BLG_F2 may be removed by using the third hard mask HM3. For example, a portion of the first stage light transmitting material layer LTM_F1, a portion of the second stage light transmitting material layer LTM_F2, and the first stage bridge BLG_F1 and the second stage bridge BLG_F2 in a portion that does not overlap the third hard mask HM3 may be removed through dry etching, but are not limited thereto.

In an embodiment, the third hard mask HM3 may include a bridge removal area BRA. The bridge removal area BRA may overlap the first stage bridge BLG_F1 and the second stage bridge BLG_F2 in the third direction DR3. A slit of the third hard mask HM3 may be positioned in the bridge removal area BRA. That is, an opening of the third hard mask HM3 may be disposed in the bridge removal area BRA.

In an embodiment, in the bridge removal area BRA, the first stage bridge BLG_F1 and the second stage bridge BLG_F2, and a portion of the first stage light transmitting material layer LTM_F1 and a portion of the second stage light transmitting material layer LTM_F2 that overlap the first stage bridge BLG_F1 and the second stage bridge BLG_F2 may be removed. Accordingly, as the second stage bridge BLG_F2 is removed, a first hole HOL1 may be formed, and as a portion of the second stage light transmitting material layer LTM_F2 overlapping the second stage bridge BLG_F2 is removed, a second hole HOL2 may be formed. Although not illustrated in the drawings, as the first stage bridge BLG_F1 is removed, a third hole may be formed, and as a portion of the first stage light transmitting material layer LTM_F1 overlapping the first stage bridge BLG_F1 is removed, a fourth hole may be formed. The first hole HOL1 and the second hole HOL2 may be one connected through hole that penetrates through the entire second light transmitting material layer LTM_F2, and the third hole and the fourth hole may be one connected through hole that penetrates through the entire first light transmitting material layer LTM_F1.

In an embodiment, the first hole HOL1 may be positioned at the same height as the first portion LTMa_F2 of the second stage light transmitting material layer LTM_F2. The first hole HOL1 may be surrounded by the first portion LTMa_F2 of the second stage light transmitting material layer LTM_F2. The first hole HOL1 may be a hole penetrating through the first portion LTMa_F2 of the second stage light transmitting material layer LTM_F2 in the third direction DR3 .

In an embodiment, the second hole HOL2 may be positioned at the same height as the second portion LTMb_F2 of the second stage light transmitting material layer LTM_F2. The second hole HOL2 may be surrounded by the second portion LTMb_F2 of the second stage light transmitting material layer LTM_F2. The second hole HOL2 may be a hole penetrating through the second portion LTMb_F2 of the second stage light transmitting material layer LTM_F2 in the third direction DR3.

In an embodiment, the third hole may be positioned at the same height as the first portion LTMa_F1 of the first stage light transmitting material layer LTM_F1. The third hole may be surrounded by the first portion LTMa_F1 of the first stage light transmitting material layer LTM_F1. The third hole may be a hole penetrating through the first portion LTMa_F1 of the first stage light transmitting material layer LTM_F1 in the third direction DR3.

In an embodiment, the fourth hole may be positioned at the same height as the second portion LTMb_F1 of the first stage light transmitting material layer LTM_F1. The fourth hole may be surrounded by the second portion LTMb_F1 of the first stage light transmitting material layer LTM_F1. The fourth hole may be a hole penetrating through the second portion LTMb_F1 of the first stage light transmitting material layer LTM_F1 in the third direction DR3.

In an embodiment, as illustrated in FIG. 37, in the step (S280) of forming the first stage light transmitting film and the second stage light transmitting film, a material included in the second stage light transmitting material layer LTM_F2 may be additionally applied to fill the first hole HOL1 and the second hole HOL2, and a material included in the first stage light transmitting material layer LTM_F1 may be additionally applied to fill the third hole and the fourth hole. Accordingly, a first portion LTa_F1 and a second portion LTb_F1 of the first stage light transmitting film LT_F1, and a first portion LTa_F2 and a second portion LTb_F2 of the second stage light transmitting film LT_F2 may be formed. In some embodiments, the materials included in the first stage light transmitting material layer LTM_F1 and the second stage light transmitting material layer LTM_F2 may be the same.

In an embodiment, although not illustrated in the drawing, the removal marks such as the concave portions CCV and the convex portions CVX described with reference to FIGS. 12 to 16 may be included in the plurality of light blocking films LS of the light control layer LCL.

In an embodiment, according to the method S2 for manufacturing the display device 10, the light control layer LCL may include a plurality of stages, thereby reducing the height of the plurality of light blocking films LS included in one stage. Accordingly, when patterning the plurality of light blocking films LS, an etch depth is reduced compared to an etch width, so that a side profile of the plurality of light blocking films LS may be formed to be close to about 90 degrees. In addition, since the height of the plurality of light blocking films LS of the light control layer LCL may be formed to be high, viewing angle control characteristics may be improved.

The invention should not be construed as being limited to the embodiments set forth herein. Rather, these embodiments are provided so that this disclosure will be thorough and complete and will fully convey the invention to those skilled in the art. While the invention has been particularly shown and described with reference to embodiments thereof, it will be understood by those of ordinary skill in the art that various changes in form and details may be made therein without departing from the scope of the invention. Moreover, the embodiments or parts of the embodiments may be combined in whole or in part without departing from the scope of the invention.

## Claims

1. A display device (10) comprising:
a substrate;
a light emitting element layer disposed on the substrate and including at least one light emitting element (170); and
a light control layer disposed on the light emitting element (170) layer, wherein
the light control layer includes:
a plurality of light blocking films disposed to be spaced apart from each other; ; and
a light transmitting film disposed between the plurality of light blocking films,
wherein the light control layer further includes at least one bridge connecting at least two of the plurality of light blocking films, and/or
wherein at least one of the plurality of light blocking films includes removal marks on a side surface thereof.

2. The display device (10) of claim 1, wherein the light transmitting film includes a first portion positioned at a same height as the plurality of light blocking films, and a second portion disposed on the plurality of light blocking films, wherein the second portion is preferably disposed across the plurality of light blocking films, the bridge, and the first portion.

3. The display device (10) of claim 1 or 2, wherein the light control layer further includes the at least one bridge and wherein the at least one bridge extends in a different direction from the plurality of light blocking films and/or wherein a width of the at least one bridge is different from, preferably greater than, a width of the plurality of light blocking films.

4. The display device (10) of any one of the preceding claims, wherein the light control layer further includes the at least one bridge and wherein the at least one bridge includes a same material as the plurality of light blocking films.

5. The display device (10) of any one of the preceding claims, further comprising a light emitting area from which light emitted by the light emitting element (170) is emitted,
wherein the light control layer further includes the at least one bridge and wherein the at least one bridge does not overlap the light emitting area.

6. The display device (10) of any one of the preceding claims 1, wherein the light control layer further includes the at least one bridge and wherein the at least one bridge connects at least two light blocking films among the plurality of light blocking films.

7. The display device (10) of claim 6, wherein
the at least one bridge includes a first bridge disposed between a (2n-1)-th light blocking film and a (2n)-th light blocking film among the plurality of light blocking films, and a second bridge disposed between the (2n)-th light blocking film and a (2n+1)-th light blocking film among the plurality of light blocking films,
where n is a natural number, and
the first bridge and the second bridge do not overlap each other.

8. The display device (10) of any one of the preceding claims, wherein the light control layer further includes the at least one bridge and wherein the light transmitting film surrounds the plurality of light blocking films and the at least one bridge.

9. The display device (10) of any one of the preceding claims, wherein
the light control layer includes a first stage and a second stage disposed on the first stage, wherein
the first stage and the second stage each include the plurality of light blocking films and the light transmitting film.

10. The display device (10) of any one of the preceding claims, wherein at least one of the plurality of light blocking films includes removal marks on a side surface thereof and wherein the removal marks are a concave portion or a convex portion.

11. The display device (10) of claim 10, wherein
the plurality of light blocking films include a first side surface and a second side surface positioned on an opposite side than the first side surface, wherein
both the first side surface and the second side surface include the concave portion, or both the first side surface and the second side surface include the convex portion, or
the first side surface includes the concave portion and the second side surface includes the convex portion, or
the first side surface includes the convex portion and the second side surface includes the concave portion, or
the first side surface and the second side surface each include both the concave portion and the convex portion, wherein the concave portion of the first side surface and the convex portion of the second side surface overlap, and wherein the convex portion of the first side surface and the concave portion of the second side surface overlap.

12. The display device (10) of any one of the preceding claims, further comprising a light emitting area from which light emitted by the light emitting element (170) is emitted,
wherein at least one of the plurality of light blocking films includes removal marks on a side surface thereof and wherein at least one of the removal marks overlaps the light emitting area.

13. The display device (10) of any one of the preceding claims,
wherein the at least one light emitting element (170) is included in at least one pixel included in the light emitting element layer;
wherein the at least one pixel includes a first light emitting mode area and a second light emitting mode area,
wherein the plurality of light blocking films include a first light blocking film disposed in the first light emitting mode area and a second light blocking film disposed in the second light emitting mode area, and
wherein extension directions of the first light blocking film and the second light blocking film are different.

14. The display device (10) of claim 13, wherein the first light blocking film and the second light blocking film are connected to each other at a boundary between the first light emitting mode area and the second light emitting mode area.

15. The display device (10) of claim 13 or 14, wherein a distance between the first light blocking films is different from a distance between the second light blocking films.

16. A method for manufacturing a display device (10), the method comprising:
forming (S110) a light blocking material layer;
forming (S120) a plurality of light blocking films and a bridge by patterning the light blocking material layer; and
forming (S130) a light transmitting material layer surrounding the plurality of light blocking films and the bridge,
wherein extension directions of the bridge and the plurality of light blocking films are different.

17. The method of claim 16, further comprising:
removing (S140) a portion of the light transmitting material layer from a light transmitting material layer area and a portion of the bridge; and
forming (S150) a light transmitting film by filling the light transmitting material layer area.

18. The method of claim 17, wherein in the removing of the bridge, a removal mark of the bridge is formed on a side surface of the plurality of light blocking films.
